# EUROPEAN PATENT SPECIFICATION

(11) **EP 3 308 401 B1**
(45) Date of publication and mention of the grant of the patent: **21.02.2024**
(21) Application number: 16729360.4
(22) Date of filing: 10.06.2016
(51) Int. Cl.: H10K 30/85, H10K 30/86, H10K 39/15, H10K 85/50

(54) **MULTIJUNCTION PHOTOVOLTAIC DEVICE**
FOTOVOLTAIKVORRICHTUNG MIT MEHRFACHÜBERGANG
DISPOSITIF PHOTOVOLTAÏQUE MULTIJONCTIONS

(30) Priority: 12.06.2015 GB 201510353; 01.09.2015 GB 201515444
(43) Date of publication of application: 18.04.2018
(73) Proprietor: Oxford Photovoltaics Limited, Mead Road Yarnton Oxfordshire OX5 1QU (GB)
(72) Inventor: ROBINSON, Anna, Yarnton, Oxfordshire OX5 1QU (GB); CASE, Christopher, Yarnton, Oxfordshire OX5 1QU (GB); KIRK, Daniel, Yarnton, Oxfordshire OX5 1QU (GB); CROSSLAND, Edward, Yarnton, Oxfordshire OX5 1QU (GB); WATTS, Jim, Yarnton, Oxfordshire OX5 1QU (GB); BEAUMONT, Nicola, Yarnton, Oxfordshire OX5 1QU (GB); BUTLER, Phillip, Yarnton, Oxfordshire OX5 1QU (GB); HOOPER, Stewart, Yarnton, Oxfordshire OX5 1QU (GB); LANGLEY, Benjamin John, Yarnton, Oxfordshire OX5 1QU (GB)
(74) Representative: Bingham, Ian Mark
(86) International application number: PCT/GB2016/051744
(87) International publication number: WO 2016/198898

(56) References cited:
- WO-A1-2014/045021
- WO-A1-2015/017885
- WO-A1-2016/157979
- HYOSUNG CHOI ET AL: "Cesium-doped methylammonium lead iodide perovskite light absorber for hybrid solar cells", NANO ENERGY, vol. 7, 6 March 2014 (2014-03-06), pages 80-85, XP055297898, ISSN: 2211-2855, DOI: 10.1016/j.nanoen.2014.04.017
- GILES E. EPERON ET AL: "Formamidinium lead trihalide: a broadly tunable perovskite for efficient planar heterojunction solar cells", ENERGY & ENVIRONMENTAL SCIENCE, vol. 7, no. 3, 6 January 2014 (2014-01-06) , pages 982-988, XP55234624, UK ISSN: 1754-5692, DOI: 10.1039/c3ee43822h

## Description

### FIELD OF THE INVENTION

The present invention relates to a monolithically integrated perovskite-on-silicon multi-junction photovoltaic device that produces a net gain in power conversion efficiency over the efficiency of the bottom silicon sub-cell in a single junction arrangement.

### BACKGROUND OF THE INVENTION

Over the past forty years or so there has been an increasing realisation of the need to replace fossil fuels with more secure sustainable energy sources. The new energy supply must also have low environmental impact, be highly efficient and be easy to use and cost effective to produce. To this end, solar energy is seen as one of the most promising technologies, nevertheless, the high cost of manufacturing devices that capture solar energy, including high material costs, has historically hindered its widespread use.

Every solid has its own characteristic energy-band structure which determines a wide range of electrical characteristics. Electrons are able to transition from one energy band to another, but each transition requires a specific minimum energy and the amount of energy required will be different for different materials. The electrons acquire the energy needed for the transition by absorbing either a phonon (heat) or a photon (light). The term "band gap" refers to the energy difference range in a solid where no electron states can exist, and generally means the energy difference (in electron volts) between the top of the valence band and the bottom of the conduction band. The efficiency of a material used in a photovoltaic device, such as a solar cell, under normal sunlight conditions is a function of the band gap for that material. If the band gap is too high, most daylight photons cannot be absorbed; if it is too low, then most photons have much more energy than necessary to excite electrons across the band gap, and the rest will be wasted. The Shockley-Queisser limit refers to the theoretical maximum amount of electrical energy that can be extracted per photon of incoming light and is about 1.34eV. The focus of much of the recent work on photovoltaic devices has been the quest for materials which have a band gap as close as possible to this maximum.

One class of photovoltaic materials that has attracted significant interest has been the perovskites. Materials of this type form an ABX₃ crystal structure which has been found to show a favourable band gap, a high absorption coefficient and long diffusion lengths, making such compounds ideal as an absorber in photovoltaic devices. Early examples of the use of perovskite materials in photovoltaic application are reported by Kojima, A. et al., 2009. Organometal halide perovskites as visible-light sensitizers for photovoltaic cells. Journal of the American Chemical Society, 131(17), pp.6050-1 in which hybrid organic-inorganic metal halide perovskites were used as the sensitizer in liquid electrolyte based photoelectrochemical cells. Kojima et al report that a highest obtained solar energy conversion efficiency (or power energy conversion efficiency, PCE) of 3.8%, although in this system the perovskite absorbers decayed rapidly and the cells dropped in performance after only 10 minutes.

Subsequently, Lee, M.M. et al., 2012. Efficient hybrid solar cells based on meso-superstructured organometal halide perovskites. Science (New York, N.Y.), 338(6107), pp.643-7 reported a "meso-superstructured solar cell" in which the liquid electrolyte was replaced with a solid-state hole conductor (or hole-transporting material, HTM), spiro-MeOTAD. Lee et al reported a significant increase in the conversion efficiency achieved, whilst also achieving greatly improved cell stability as a result of avoiding the use of a liquid solvent. In the examples described, CH₃NH₃PbI₃ perovskite nanoparticles assume the role of the sensitizer within the photovoltaic cell, injecting electrons into a mesoscopic TiO₂ scaffold and holes into the solid-state HTM. Both the TiOz and the HTM act as selective contacts through which the charge carriers produced by photoexcitation of the perovskite nanoparticles are extracted.

Further work described in WO2013/171517 disclosed how the use of mixed-anion perovskites as a sensitizer/absorber in photovoltaic devices, instead of single-anion perovskites, results in more stable and highly efficient photovoltaic devices. In particular, this document discloses that the superior stability of the mixed-anion perovskites is highlighted by the finding that the devices exhibit negligible colour bleaching during the device fabrication process, whilst also exhibiting full sun power conversion efficiency of over 10%. In comparison, equivalent single-anion perovskites are relatively unstable, with bleaching occurring quickly when fabricating films from the single halide perovskites in ambient conditions.

More recently, WO2014/045021 described planar heterojunction (PHJ) photovoltaic devices comprising a thin film of a photoactive perovskite absorber disposed between n-type (electron transporting) and p-type (hole transporting) layers. Unexpectedly it was found that good device efficiencies could be obtained by using a compact (i.e. without effective/open porosity) thin film of the photoactive perovskite, as opposed to the requirement of a mesoporous composite, demonstrating that perovskite absorbers can function at high efficiencies in simplified device architectures.

Recently some of research into the application of perovskites in photovoltaic devices has focussed on the potential of these materials to boost the performance of conventional silicon-based solar cells by combining them with a perovskite-based cell in a tandem/multi-junction arrangement. In this regard, a multi-junction photovoltaic device comprises multiple separate sub-cells (i.e. each with their own photoactive region) that are "stacked" on top of each other and that together convert more of the solar spectrum into electricity thereby increasing the overall efficiency of the device. To do so, each photoactive region of each sub-cell is selected so that the band gap of the photoactive region ensures that it will efficiently absorbs photons from a specific segment of the solar spectrum. This has two important advantages over conventional single-junction photovoltaic devices. Firstly the combination of multiple sub-cells/photoactive regions with different band gaps ensures that a wider range of incident photons can be absorbed by a multi-junction device, and secondly each sub-cell/photoactive region will be more effective at extracting energy from the photons within the relevant part of the spectrum. In particular, the lowest band gap of a multi-junction photovoltaic device will be lower than that of a typical single junction device, such that a multi-junction device will be able to absorb photons that possess less energy than those that can be absorbed by a single junction device. Furthermore, for those photons that would be absorbed by both a multi-junction device and a single junction device, the multi-junction device will absorb those photons more efficiently, as having band gaps closer to the photon energy reduces thermalization losses.

In a multi-junction device, the top sub-cell/photoactive region in the stack has the highest band gap, with the band gap of the lower sub-cells/photoactive regions reducing towards the bottom of the device. This arrangement maximizes photon energy extraction as the top sub-cell/photoactive region absorbs the highest energy photons whilst allowing the transmission of photons with less energy. Each subsequent sub-cell/photoactive region then extracts energy from photons closest to its band gap thereby minimizing thermalization losses. The bottom sub-cell/photoactive region then absorbs all remaining photons with energy above its band gap. When designing multi-junction cells it is therefore important to choose sub-cells whose photoactive regions with the right bandgaps in order to optimise harvesting of the solar spectrum. In this regard, for a tandem photovoltaic device that comprises two sub-cells/photoactive regions, a top sub-cell/photoactive region and a bottom sub-cell/photoactive region, it has been shown that the bottom sub-cell/photoactive region should ideally have a band gap of around 1.1 eV whilst the top sub-cell/photoactive region should ideally have a band gap of around 1.7eV (Coutts, T.J., Emery, K. a. & Scott Ward, J., 2002. Modeled performance of polycrystalline thin-film tandem solar cells. Progress in Photovoltaics: Research and Applications, 10(3), pp.195-203).

Consequently, there has been interest in developing hybrid organic-inorganic perovskite solar cells for use in tandem photovoltaic devices given that the band gap of these perovskite materials can be tuned from around 1.5eV to over 2eV by varying the halide composition of organometal halide perovskites (Noh, J.H. et al., 2013. Chemical Management for Colourful, Efficient, and Stable Inorganic-Organic Hybrid Nanostructured Solar Cells. Nano letters, 2, pp.28-31). In particular, by varying the halide composition it is possible to tune the band gap of an organometal halide perovskite to around 1.7eV, such that it is then ideal for use as the top sub-cell in a tandem structure when combined with a crystalline silicon bottom sub-cell which has a band gap of around 1.12eV.

In this regard, Schneider, B.W. et al (Schneider, B.W. et al., 2014. Pyramidal surface textures for light trapping and antireflection in perovskite-on-silicon tandem solar cells. Optics Express, 22(S6), p.A1422) reported on the modelling of a perovskite-on-silicon tandem cell in which the modelled cell has a 4-terminal, mechanically stacked structure. Löper, P. et al (Löper, P. et al., 2015. Organic-inorganic halide perovskite/crystalline silicon four-terminal tandem solar cells. Physical chemistry chemical physics: PCCP, 17, p.1619) reported on the implementation of a four-terminal tandem solar cell consisting of a methyl ammonium lead triiodide (CH₃NH₃PbI₃) (i.e. organometal halide perovskite) top sub-cell mechanically stacked on a crystalline silicon heterojunction bottom sub-cell. Similarly, Bailie, C. et al. (Bailie, C. et al., 2015. Semi-transparent perovskite solar cells for tandems with silicon and CIGS. Energy Environ. Sci., pp.1-28) reported on a mechanically-stacked tandem solar cell consisting of a methyl ammonium lead triiodide (CH₃NH₃PbI₃) top sub-cell on a copper indium gallium diselenide (CIGS) or low-quality multi-crystalline silicon bottom sub-cell. Filipic, M. et al. (Filipic, M. et al., 2015. CH3NH3PbI3 perovskite / silicon tandem solar cells: characterization based optical simulations. Optics Express, 23(7), pp.480-484) reported on the simulation of both mechanically stacked (four terminal) and monolithically integrated (two terminal) tandem devices consisting of a methyl ammonium lead triiodide (CH₃NH₃PbI₃) top sub-cell and a crystalline silicon bottom sub-cell. Mailoa, J.P. et al. (Mailoa, J.P. et al., 2015. A 2-terminal perovskite/silicon multi-junction solar cell enabled by a silicon tunnel junction. Applied Physics Letters, 106(12), p. 121105) then reported on the fabrication of a monolithic tandem solar cell consisting of a methyl ammonium lead triiodide (CH₃NH₃PbI₃) top sub-cell and a crystalline silicon bottom sub-cell.

In a mechanically stacked multi-junction photovoltaic device the individual sub-cells are stacked on top of each other and are each provided with their own separate electrical contacts, such that the individual sub-cells are connected in parallel and do not require current matching. This contrasts with a monolithically integrated multi-junction photovoltaic device in which the individual sub-cells are electrically connected in series between a single pair of terminals, which results in the need for a recombination layer or a tunnel junction and current matching between adjacent sub-cells. Whilst a mechanically stacked multi-junction photovoltaic device does not require current matching between the sub-cells, the additional size and cost of the additional contacts and substrates, and a lower practical efficiency limit, make mechanically stacked structures less favourable than monolithically integrated structures.

To date the only working example of a monolithically integrated perovskite-on-silicon multi-junction photovoltaic device produced a net loss in power conversion efficiency when compared with the efficiency of the bottom silicon sub-cell in a single junction arrangement. In this regard, Mailoa, J.P. et al reported a 2-terminal perovskite-on-silicon multi-junction photovoltaic device in which the efficiency of the single-junction silicon cell is 13.8% whilst the reported best efficiency for the 2-terminal multi-junction device is 13.7%.

### SUMMARY OF THE PRESENT INVENTION

The inventors have developed a monolithically integrated perovskite-on-silicon multi-junction photovoltaic device that produces a net gain in power conversion efficiency over the efficiency of the bottom silicon sub-cell in a single junction arrangement.

According to the invention, there is provided a multi-junction photovoltaic device comprising:
a first sub-cell disposed over a second sub-cell,
wherein the first sub-cell comprises an n-type region comprising at least one n-type layer, a p-type region comprising at least one p-type layer, and a photoactive region comprising a layer of perovskite material without open porosity that is disposed between the n-type region and the p-type region and that forms a planar heterojunction with one or both of the n-type region and the p-type region;
wherein the perovskite material is of general formula (IA):

   AₓA'₁₋ₓB(X_{y}X'_{1-y})₃ (IA)
wherein A is a formamidinium cation (FA), A' is a caesium cation (Cs⁺), B is Pb²⁺, X is iodide and X' is bromide, and wherein 0< x <1 and 0 < y ≤ 1; and
wherein the second sub-cell comprises a silicon heterojunction (SHJ).

A surface of the second sub-cell that is adjacent to the first sub-cell may be textured with a surface profile having a roughness average (Rₐ) of less than 500 nm.

The surface of the second sub-cell that is adjacent to the first sub-cell preferably has a roughness average (Rₐ) of between 50 and 450 nm. In a preferred embodiment, the surface of the second sub-cell that is adjacent to the first sub-cell has a roughness average (Rₐ) of between 100 and 400 nm, and more preferably has a roughness average (Rₐ) from 200 nm to 400 nm.

The surface of the second sub-cell that is adjacent to the first sub-cell may have a root mean square roughness (Rᵣₘₛ) of less than or equal to 50 nm. The surface of the second sub-cell that is adjacent to the first sub-cell may have a peak-to-peak roughness (Rₜ) from 100 nm to 400 nm, and preferably of approximately 250 nm. The surface of the second sub-cell that is adjacent to the first sub-cell may have a mean spacing between peaks (Sₘ) from 10 µm to 50 µm, and preferably of approximately 25 µm.

Optionally, the surface of the second sub-cell that is adjacent to the first sub-cell has an undulating profile.

The layer of perovskite material is preferably disposed as a substantially continuous and conformal layer on a surface that conforms to the adjacent surface of the second sub-cell.

The device may further comprise an intermediate region disposed between and connecting the first sub-cell and the second sub-cell, wherein the intermediate region comprises one or more interconnect layers. Each of the one or more interconnect layers preferably comprises a transparent conductor material. Each of the one or more interconnect layers preferably has an average transmission for near-infrared and infrared light of at least 90% and a sheet resistance (Rs) equal to or less than 200 ohms per square (Ω/sq). The intermediate region may comprise an interconnect layer that consists of indium tin oxide (ITO), and preferably the layer of ITO has a thickness of from 10 nm to 60nm.

The photoactive region of the first sub-cell comprises a layer of the perovskite material without open porosity. The photoactive region of the first sub-cell comprises an n-type region comprising at least one n-type layer, and a p-type region comprising at least one p-type layer; wherein the layer of the perovskite material is disposed between the n-type region and the p-type region. The layer of perovskite material may then form a planar heterojunction with one or both of the n-type region and the p-type region.

The n-type region may comprise an n-type layer that comprises an inorganic n-type material. The inorganic n-type material may be selected from any of: an oxide of titanium, tin, zinc, niobium, tantalum, tungsten, indium, gallium, neodymium, palladium, cadmium, or an oxide of a mixture of two or more of said metals; a sulphide of cadmium, tin, copper, zinc or a sulphide of a mixture of two or more of said metals; a selenide of cadmium, zinc, indium, gallium or a selenide of a mixture of two or more of said metals; and a telluride of cadmium, zinc, cadmium or tin, or a telluride of a mixture of two or more of said metals. The n-type region may comprise an n-type layer that comprises TiO₂, and preferably the n-type layer is then a compact layer of TiO₂.

The n-type region may comprise an n-type layer that comprises an organic n-type material. The organic n-type material may be selected from any of a fullerene or a fullerene derivative, a perylene or a derivative thereof, or poly{[N,N0-bis(2-octyldodecyl)-naphthalene-1,4,5,8-bis(dicarboximide)-2,6-diyl]-alt-5,50-(2,20-bithiophene)} (P(NDI2OD-T2)).

The n-type region may comprise an n-type layer that has a thickness of from 20 nm to 40nm, and more preferably 30 nm. Optionally, the n-type region consists of an n-type layer that has a thickness of from 20 nm to 40nm, and more preferably 30 nm.

The p-type region may comprise a p-type layer that comprises an inorganic p-type material. The inorganic p-type material may be selected from any of: an oxide of nickel, vanadium, copper or molybdenum; and CuI, CuBr, CuSCN, Cu₂O, CuO or CIS.

The p-type region may comprise a p-type layer that comprises an organic p-type material. The organic p-type material may be selected from any of spiro-MeOTAD, P3HT, PCPDTBT, PVK, PEDOT-TMA, PEDOT:PSS, and preferably the p-type region consists of a p-type layer that comprises spiro-MeOTAD.

The p-type region may comprise a p-type layer that has a thickness of from 200 nm to 300 nm, and more preferably 250 nm. Optionally, the p-type region consists of a p-type layer that has a thickness of from 200 nm to 300 nm, and more preferably 250 nm.

The n-type region may be adjacent to the second sub-cell.

The device may further comprise a first electrode and a second electrode; and wherein the first sub-cell and the second sub-cell are disposed between the first and second electrodes with the first sub-cell in contact with the first electrode. The first electrode may be in contact with the p-type region of the first sub-cell.

The first electrode may comprise a transparent or semi-transparent electrically conductive material. The first electrode may consist of material that has a sheet resistance (Rs) equal to or less than 50 ohms per square (Ω/sq) and an average transmission for visible and infrared light of greater than 90%, and preferably has an average transmission for visible and infrared light of at least 95%. The first electrode may consist of a layer of indium tin oxide (ITO), and preferably the layer of ITO has a thickness of from 100 nm to 200 nm, and more preferably of 150 nm.

The photoactive region of the first sub-cell may comprises a layer of perovskite material having a band gap from 1.50eV to 1.75eV, and preferably from 1.65eV to 1.70eV.

The second sub-cell may comprise a bifacial sub-cell, and the device then further comprises a third sub-cell disposed below the second sub-cell, the third sub-cell comprising a photoactive region comprising a layer of perovskite material. The photoactive region of the third sub-cell may comprise a layer of perovskite material that is either the same as or different to the perovskite material of the photoactive region of the first sub-cell. The first sub-cell may have a regular structure and the third sub-cell may then have an inverted structure.

A surface of the second sub-cell that is adjacent to the third sub-cell may have a root mean square roughness (Rᵣₘₛ) of less than or equal to 50 nm. A surface of the second sub-cell that is adjacent to the third sub-cell may have a peak-to-peak roughness (Rₜ) from 100 nm to 400 nm, and preferably of 250 nm. A surface of the second sub-cell that is adjacent to the third sub-cell may have a mean spacing between peaks (Sₘ) from 10 µm to 50 µm, and preferably of 25 µm. A surface of the second sub-cell that is adjacent to the third sub-cell may have an undulating profile. The layer of perovskite material of the third sub-cell may then be disposed as a substantially continuous and conformal layer on a surface that conforms to the adjacent surface of the second sub-cell.

The device may further comprise a further intermediate region disposed between and connecting the third sub-cell and the second sub-cell, wherein the further intermediate region comprises one or more further interconnect layers. Each of the one or more further interconnect layers preferably consists of a transparent conductor material. Each of the one or more further interconnect layers may have an average transmission for near-infrared and infrared light of at least 90% and a sheet resistance (Rs) equal to or less than 200 ohms per square (Ω/sq). The intermediate region may comprise a further interconnect layer that consists of indium tin oxide (ITO), and preferably the layer of ITO has a thickness of from 10 nm to 60nm.

The photoactive region of the third sub-cell may further comprise an n-type region comprising at least one n-type layer; a p-type region comprising at least one p-type layer; and wherein the layer of the perovskite material is disposed between the n-type region and the p-type region. The p-type region of the third sub-cell may be adjacent to the second sub-cell.

The third sub-cell may be disposed between the first and second electrodes with the third sub-cell in contact with the second electrode. The second electrode may then be in contact with the n-type region of the photoactive region of the third sub-cell.

The second electrode may comprise a transparent or semi-transparent electrically conductive material. The second electrode may consist of material that has a sheet resistance (Rs) equal to or less than 50 ohms per square (Ω/sq) and an average transmission for visible and infrared light of greater than 90%, and preferably has an average transmission for visible and infrared light of at least 95%. The second electrode may consist of a layer of indium tin oxide (ITO), and preferably the layer of ITO has a thickness of from 100 nm to 200 nm, and more preferably of 150 nm.

The photoactive region of the third sub-cell may comprise a layer of perovskite material having a band gap from 1.50eV to 1.75eV, and is preferably from 1.65eV to 1.70eV.

There is also provided a photovoltaic device comprising a photoactive region comprising a layer of organic charge transport material; and a layer of a transparent conducting oxide (TCO) material that has been deposited onto the layer of organic charge transport material. The layer of TCO material has a sheet resistance (Rₛ) equal to or less than 50 ohms per square (Ω/sq) and an average transmission for visible and infrared light of greater than 90%, and that preferably has an average transmission for visible and infrared light of at least 95 %. The layer of TCO material may have an amorphous structure.

The photoactive region may comprise a photoactive perovskite material, and the layer of organic charge transport material may then be disposed above the photoactive perovskite material. The organic charge transport material may be any of an n-type material and a p-type material.

According to a third aspect there is provided a method of producing a photovoltaic device. The method comprises depositing a layer of organic charge transport material; and depositing a layer a transparent conducting oxide (TCO) material onto the organic charge transport material using a remote plasma sputtering process.

A plasma directed at a sputtering target by the remote plasma sputtering process may have a density from 10¹¹ ions. cm⁻³ to 5 × 10¹³ ions. cm⁻³. Ions in the plasma may have an energy from 30 eV to 50 eV. The step of depositing the layer of TCO may be performed at a temperature below 100°C. The method does not comprise a step in which the deposited layer of TCO is annealed at temperatures of 200°C or higher.

The photovoltaic device may comprises a photoactive region comprising the layer of organic charge transport material and a layer of photoactive perovskite material, and the step of depositing a layer of organic charge transport material may then comprise depositing the layer of organic charge transport material onto the layer of photoactive perovskite material.

In addition, there is provided a multi-junction photovoltaic device comprising a first sub-cell disposed over a second sub-cell, the first sub-cell comprising a photoactive region comprising a layer of perovskite material; wherein a surface of the second sub-cell that is adjacent to the first sub-cell has a root mean square roughness (Rᵣₘₛ) of less than or equal to 50 nm.

A surface of the second sub-cell that is adjacent to the first sub-cell may have a peak-to-peak roughness (Rₜ) from 100 nm to 400 nm, and preferably of approximately 250 nm. A surface of the second sub-cell that is adjacent to the first sub-cell may have a mean spacing between peaks (Sₘ) from 10 µm to 50 µm, and preferably of approximately 25 µm. A surface of the second sub-cell that is adjacent to the first sub-cell may have an undulating profile. The layer of perovskite material may be disposed as a substantially continuous and conformal layer on a surface that conforms to the adjacent surface of the second sub-cell.

### BRIEF DESCRIPTION OF THE DRAWINGS

The present invention will now be more particularly described by way of example only with reference to the accompanying drawings, in which:
Figure 1 illustrates schematically a monolithically integrated multi-junction photovoltaic device that comprises a top, perovskite based sub-cell and a bottom, silicon heterojunction (SHJ) sub-cell;
Figure 2 illustrates schematically an example of a silicon heterojunction (SHJ) sub-cell;
Figure 3a illustrates schematically an example of a perovskite based sub-cell that has an extremely thin absorber (ETA) cell architecture;
Figure 3b illustrates schematically an example of a perovskite based sub-cell that has a meso-superstructured solar cell (MSSC) architecture;
Figure 3c illustrates schematically an example of a perovskite based sub-cell that has a planar heterojunction device architecture;
Figure 3d illustrates schematically an example of a perovskite based sub-cell in which the perovskite forms a bulk heterojunction with a semiconducting porous scaffold material;
Figure 3e illustrates schematically an example of a HTM-free perovskite based sub-cell in which the perovskite forms a bulk heterojunction with a semiconducting porous scaffold material;
Figure 3f illustrates schematically an example of a perovskite based sub-cell in which the perovskite forms a bulk heterojunction with an insulating porous scaffold material;
Figure 4 illustrates schematically an example of the monolithically integrated multi-junction photovoltaic device of Figure 1;
Figure 5 illustrates schematically an example of the surface profile of the second sub-cell of a monolithically integrated multi-junction photovoltaic device;
Figure 6 illustrates schematically a bifacial monolithically integrated multi-junction photovoltaic device;
Figure 7 illustrates schematically an example of the bifacial monolithically integrated multi-junction photovoltaic device of Figure 6;
Figures 8 and 9 show I-V curves and the calculated device characteristics for samples of an n-type crystalline silicon heterojunction (SHJ) sub-cell; and
Figures 10 and 11 show I-V curves and the calculated device characteristics for multi-junction devices that each comprise a perovskite-based sub-cell monolithically integrated on to an n-type crystalline silicon heterojunction (SHJ) sub-cell.

### DETAILED DESCRIPTION

### Definitions

The term "photoactive", as used herein, refers to a region, layer or material that is capable of responding to light photoelectrically. A photoactive region, layer or material is therefore capable of absorbing the energy carried by photons in light that then results in the generation of electricity (e.g. by generating either electron-hole pairs or excitons).

The term "perovskite", as used herein, refers to a material with a three-dimensional crystal structure related to that of CaTiO₃ or a material comprising a layer of material, which layer has a structure related to that of CaTiO₃. The structure of CaTiO₃ can be represented by the formula ABX₃, wherein A and B are cations of different sizes and X is an anion. In the unit cell, the A cations are at (0,0,0), the B cations are at (1/2, 1/2, 1/2) and the X anions are at (1/2, 1/2, 0). The A cation is usually larger than the B cation. The skilled person will appreciate that when A, B and X are varied, the different ion sizes may cause the structure of the perovskite material to distort away from the structure adopted by CaTiO₃ to a lower-symmetry distorted structure. The symmetry will also be lower if the material comprises a layer that has a structure related to that of CaTiO₃. Materials comprising a layer of perovskite material are well known. For instance, the structure of materials adopting the K₂NiF₄ type structure comprises a layer of perovskite material. The skilled person will appreciate that a perovskite material can be represented by the formula [A][B][X]₃, wherein [A] is at least one cation, [B] is at least one cation and [X] is at least one anion. When the perovskite comprises more than one A cation, the different A cations may distributed over the A sites in an ordered or disordered way. When the perovskite comprises more than one B cation, the different B cations may distributed over the B sites in an ordered or disordered way. When the perovskite comprise more than one X anion, the different X anions may distributed over the X sites in an ordered or disordered way. The symmetry of a perovskite comprising more than one A cation, more than one B cation or more than one X cation, will often be lower than that of CaTiO₃.

As mentioned in the preceding paragraph, the term "perovskite", as used herein, refers to (a) a material with a three-dimensional crystal structure related to that of CaTiO₃ or (b) a material comprising a layer of material, wherein the layer has a structure related to that of CaTiO3. Although both of these categories of perovskite may be used in the devices, it is preferable in some circumstances to use a perovskite of the first category, (a), i.e. a perovskite having a three-dimensional (3D) crystal structure. Such perovskites typically comprise a 3D network of perovskite unit cells without any separation between layers. Perovskites of the second category, (b), on the other hand, include perovskites having a two-dimensional (2D) layered structure. Perovskites having a 2D layered structure may comprise layers of perovskite unit cells that are separated by (intercalated) molecules; an example of such a 2D layered perovskite is [2-(1-cyclohexenyl)ethylammonium]₂PbBr₄. 2D layered perovskites tend to have high exciton binding energies, which favours the generation of bound electron-hole pairs (excitons), rather than free charge carriers, under photoexcitation. The bound electronhole pairs may not be sufficiently mobile to reach the p-type or n-type contact where they can then transfer (ionise) and generate free charge. Consequently, in order to generate free charge, the exciton binding energy has to be overcome, which represents an energetic cost to the charge generation process and results in a lower voltage in a photovoltaic cell and a lower efficiency. In contrast, perovskites having a 3D crystal structure tend to have much lower exciton binding energies (on the order of thermal energy) and can therefore generate free carriers directly following photoexcitation. Accordingly, the perovskite semiconductor employed in the devices and processes is preferably a perovskite of the first category, (a), i.e. a perovskite which has a three-dimensional crystal structure. This is particularly preferable when the optoelectronic device is a photovoltaic device.

The perovskite material employed in the present invention is one which is capable of absorbing light and thereby generating free charge carriers. Thus, the perovskite employed is a light-absorbing perovskite material.

As the skilled person will appreciate, the perovskite material may be a perovskite which acts as an n-type, electron-transporting semiconductor when photo-doped. Alternatively, it may be a perovskite which acts as a p-type hole-transporting semiconductor when photo-doped. Thus, the perovskite may be n-type or p-type, or it may be an intrinsic semiconductor. In preferred embodiments, the perovskite employed is one which acts as an n-type, electron-transporting semiconductor when photo-doped. The perovskite material may exhibit ambipolar charge transport, and therefore act as both n-type and p-type semiconductor. In particular, the perovskite may act as both n-type and p-type semiconductor depending upon the type of junction formed between the perovskite and an adjacent material.

Typically, the perovskite semiconductor is a photosensitizing material, i.e. a material which is capable of performing both photogeneration and charge transportation.

The term "mixed-anion", as used herein, refers to a compound comprising at least two different anions. The term "halide" refers to an anion of an element selected from Group 17 of the Periodic Table of the Elements, i.e., of a halogen. Typically, halide anion refers to a fluoride anion, a chloride anion, a bromide anion, an iodide anion or an astatide anion.

The term "metal halide perovskite", as used herein, refers to a perovskite, the formula of which contains at least one metal cation and at least one halide anion. The term "organometal halide perovskite", as used herein, refers to a metal halide perovskite, the formula of which contains at least one organic cation.

The term "organic material" takes its normal meaning in the art. Typically, an organic material refers to a material comprising one or more compounds that comprise a carbon atom. As the skilled person would understand it, an organic compound may comprise a carbon atom covalently bonded to another carbon atom, or to a hydrogen atom, or to a halogen atom, or to a chalcogen atom (for instance an oxygen atom, a sulphur atom, a selenium atom, or a tellurium atom). The skilled person will understand that the term "organic compound" does not typically include compounds that are predominantly ionic such as carbides, for instance. The term "organic cation" refers to a cation comprising carbon. The cation may comprise further elements, for example, the cation may comprise hydrogen, nitrogen or oxygen. The term "inorganic cation" refers to a cation that is not an organic cation. By default, the term "inorganic cation" refers to a cation that does not contain carbon.

The term "semiconductor", as used herein, refers to a material with electrical conductivity intermediate in magnitude between that of a conductor and a dielectric. A semiconductor may be an n-type semiconductor, a p-type semiconductor or an intrinsic semiconductor.

The term "dielectric", as used herein, refers to material which is an electrical insulator or a very poor conductor of electric current. The term dielectric therefore excludes semiconducting materials such as titania. The term dielectric, as used herein, typically refers to materials having a band gap of equal to or greater than 4.0 eV (The band gap of titania is about 3.2 eV.)

The term "n-type", as used herein, refers to a region, layer or material that comprises an extrinsic semiconductor with a larger concentration of electrons than holes. In n-type semiconductors, electrons are therefore majority carriers and holes are the minority carriers, and they are therefore electron transporting materials. The term "n-type region", as used herein, therefore refers to a region of one or more electron transporting (i.e. n-type) materials. Similarly, the term "n-type layer" refers to a layer of an electron-transporting (i.e. an n-type) material. An electron-transporting (i.e. an n-type) material could be a single electron-transporting compound or elemental material, or a mixture of two or more electron-transporting compounds or elemental materials. An electron-transporting compound or elemental material may be undoped or doped with one or more dopant elements.

The term "p-type", as used herein, refers to a region, layer or material that comprises an extrinsic semiconductor with a larger concentration of holes than electrons. In p-type semiconductors, holes are the majority carriers and electrons are the minority carriers, and they are therefore hole transporting materials. The term "p-type region", as used herein, therefore refers to a region of one or more hole transporting (i.e. p-type) materials. Similarly, the term "p-type layer" refers to a layer of a hole-transporting (i.e. a p-type) material. A hole-transporting (i.e. a p-type) material could be a single hole-transporting compound or elemental material, or a mixture of two or more hole-transporting compounds or elemental materials. A hole-transporting compound or elemental material may be undoped or doped with one or more dopant elements.

The term "band gap", as used herein, refers to the energy difference between the top of the valence band and the bottom of the conduction band in a material. The skilled person may readily measure the band gap of a material without undue experimentation.

The term "layer", as used herein, refers to any structure which is substantially laminar in form (for instance extending substantially in two perpendicular directions, but limited in its extension in the third perpendicular direction). A layer may have a thickness which varies over the extent of the layer. Typically, a layer has approximately constant thickness. The "thickness" of a layer, as used herein, refers to the average thickness of a layer. The thickness of layers may easily be measured, for instance by using microscopy, such as electron microscopy of a cross section of a film, or by surface profilometry for instance using a stylus profilometer.

The term "porous", as used herein, refers to a material within which pores are arranged. Thus, for instance, in a porous material the pores are volumes within the body of the material where there is no material. The individual pores may be the same size or different sizes. The size of the pores is defined as the "pore size". The limiting size of a pore, for most phenomena in which porous solids are involved, is that of its smallest dimension which, in the absence of any further precision, is referred to as the width of the pore (i.e. the width of a slit-shaped pore, the diameter of a cylindrical or spherical pore, etc.). To avoid a misleading change in scale when comparing cylindrical and slit-shaped pores, one should use the diameter of a cylindrical pore (rather than its length) as its "pore-width " (Rouquerol, J. et al, (1994) Recommendations for the characterization of porous solids (Technical Report). Pure and Applied Chemistry, 66(8)). The following distinctions and definitions were adopted in previous IUPAC documents (J. Haber. (1991) Manual on catalyst characterization (Recommendations 1991). Pure and Applied Chemistry.): micropores have widths (i.e. pore sizes) smaller than 2 nm; Mesopores have widths (i.e. pore sizes) of from 2 nm to 50 nm; and Macropores have widths (i.e. pore sizes) of greater than 50 nm. In addition, nanopores may be considered to have widths (i.e. pore sizes) of less than 1 nm.

Pores in a material may include "closed" pores as well as open pores. A closed pore is a pore in a material which is a non-connected cavity, i.e. a pore which is isolated within the material and not connected to any other pore and which cannot therefore be accessed by a fluid to which the material is exposed. An "open pore" on the other hand, would be accessible by such a fluid. The concepts of open and closed porosity are discussed in detail in J. Rouquerol et al.

Open porosity, therefore, refers to the fraction of the total volume of the porous material in which fluid flow could effectively take place. It therefore excludes closed pores. The term "open porosity" is interchangeable with the terms "connected porosity" and "effective porosity", and in the art is commonly reduced simply to "porosity". The term "without open porosity", as used herein, therefore refers to a material with no effective porosity. Thus, a material without open porosity typically has no macropores and no mesopores. A material without open porosity may comprise micropores and nanopores, however. Such micropores and nanopores are typically too small to have a negative effect on a material for which low porosity is desired.

In addition, polycrystalline materials are solids that are composed of a number of separate crystallites or grains, with grain boundaries at the interface between any two crystallites or grains in the material. A polycrystalline material can therefore have both interparticle/interstitial porosity and intraparticle/internal porosity. The terms "interparticle porosity" and "interstitial porosity", as used herein, refer to pores between the crystallites or grains of the polycrystalline material (i.e. the grain boundaries), whilst the terms "intraparticle porosity" and "internal porosity", as used herein, refer to pores within the individual crystallites or grains of the polycrystalline material. In contrast, a single crystal or monocrystalline material is a solid in which the crystal lattice is continuous and unbroken throughout the volume of the material, such that there are no grain boundaries and no interparticle/interstitial porosity.

The term "compact layer", as used herein, refers to a layer without mesoporosity or macroporosity. A compact layer may sometimes have microporosity or nanoporosity.

The term "scaffold material", as used herein, therefore refers to a material that is capable of acting as a support for a further material. The term "porous scaffold material", as used herein, therefore refers to a material which is itself porous, and which is capable of acting as a support for a further material.

The term "transparent", as used herein, refers to material or object allows light to pass through almost undisturbed so that objects behind can be distinctly seen. The term "semi-transparent", as used herein, therefore refers to material or object which has a transmission (alternatively and equivalently referred to as a transmittance) to light intermediate between a transparent material or object and an opaque material or object. Typically, a transparent material will have an average transmission for light of around 100%, or from 90 to 100%. Typically, an opaque material will have an average transmission for light of around 0%, or from 0 to 5%. A semi-transparent material or object will typically have an average transmission for light of from 10 to 90%, typically 40 to 60%. Unlike many translucent objects, semi-transparent objects do not typically distort or blur images. Transmission for light may be measured using routine methods, for instance by comparing the intensity of the incident light with the intensity of the transmitted light.

The term "electrode", as used herein, refers to a conductive material or object through which electric current enters or leaves an object, substance, or region. The term "negative electrode", as used herein, refers to an electrode through which electrons leave a material or object (i.e. an electron collecting electrode). A negative electrode is typically referred to as an "anode". The term "positive electrode", as used herein, refers to an electrode through which holes leave a material or object (i.e. a hole collecting electrode). A positive electrode is typically referred to as a "cathode". Within a photovoltaic device, electrons flow from the positive electrode/cathode to the negative electrode/anode, whilst holes flow from the negative electrode/anode to the positive electrode/cathode.

The term "front electrode", as used herein, refers to the electrode provided on that side or surface of a photovoltaic device that it is intended will be exposed to sun light. The front electrode is therefore typically required to be transparent or semi-transparent so as to allow light to pass through the electrode to the photoactive layers provided beneath the front electrode. The term "back electrode", as used herein, therefore refers to the electrode provided on that side or surface of a photovoltaic device that is opposite to the side or surface that it is intended will be exposed to sun light.

The term "charge transporter" refers to a region, layer or material through which a charge carrier (i.e. a particle carrying an electric charge), is free to move. In semiconductors, electrons act as mobile negative charge carriers and holes act as mobile positive charges. The term "electron transporter" therefore refers to a region, layer or material through which electrons can easily flow and that will typically reflect holes (a hole being the absence of an electron that is regarded as a mobile carrier of positive charge in a semiconductor). Conversely, the term "hole transporter" refers to a region, layer or material through which holes can easily flow and that will typically reflect electrons.

The term "consisting essentially of" refers to a composition comprising the components of which it consists essentially as well as other components, provided that the other components do not materially affect the essential characteristics of the composition. Typically, a composition consisting essentially of certain components will comprise greater than or equal to 95 wt% of those components or greater than or equal to 99 wt% of those components.

The term "volatile compound", as used herein, refers to a compound which is easily removed by evaporation or decomposition. For instance a compound which is easily removed by evaporation or decomposition at a temperature of less than or equal to 150°C, or for instance at a temperature of less than or equal to 100°C, would be a volatile compound. "Volatile compound" also includes compounds which are easily removed by evaporation via decomposition products. Thus, a volatile compound X may evaporate easily thorough evaporation of molecules of X, or a volatile compound X may evaporate easily by decomposing to form two compounds Y and Z which evaporate easily. For instance, ammonium salts can be volatile compounds, and may either evaporate as molecules of the ammonium salt or as decomposition products, for instance ammonium and a hydrogen compound (e.g. a hydrogen halide). Thus, a volatile compound X may have a relatively high vapour pressure (e.g. greater than or equal to 500 Pa) or may have a relatively high decomposition pressure (e.g. greater than or equal to 500 Pa for one or more of the decomposition products), which may also be referred to as a dissociation pressure.

The term "roughness", as used herein, refers to the texture of a surface or edge and the extent to which it is uneven or irregular (and therefore lacks smoothness or regularity). The roughness of a surface can be quantified by any measure of the deviations of the surface in a direction that is typically normal to the average surface. As a measure of roughness, the roughness average or mean roughness (Rₐ) is the arithmetical mean of the absolute values of all deviations from a straight line within a specified reference or sampling length of the surface profile. As an alternative measure of roughness, the root mean square roughness (Rᵣₘₛ or R_{q}) is the root mean square of the values of all deviations from a straight line within a specified reference or sampling length of the surface profile.

The term "bifacial", as used herein, refers to a photovoltaic device/solar cell/sub-cell that can collect light and generate electricity through both of its faces; the front, sun-exposed face and the rear face. Bifacial devices/cells achieve a power gain by making use of diffuse and reflected light as well as direct sunlight. In contrast, the term "monofacial" refers to a photovoltaic device/solar cell/sub-cell that can only collect light and generate electricity through its front, sun-exposed face.

The term "conform", as used herein, refers to an object that is substantially the same in form or shape as an another object. A "conformal layer", as used herein, therefore refers to a layer of material that conforms to the contours of the surface on which the layer is formed. In other words, the morphology of the layer is such that the thickness of the layer is approximately constant across the majority of the interface between the layer and the surface on which the layer is formed.

### Device Structure - General

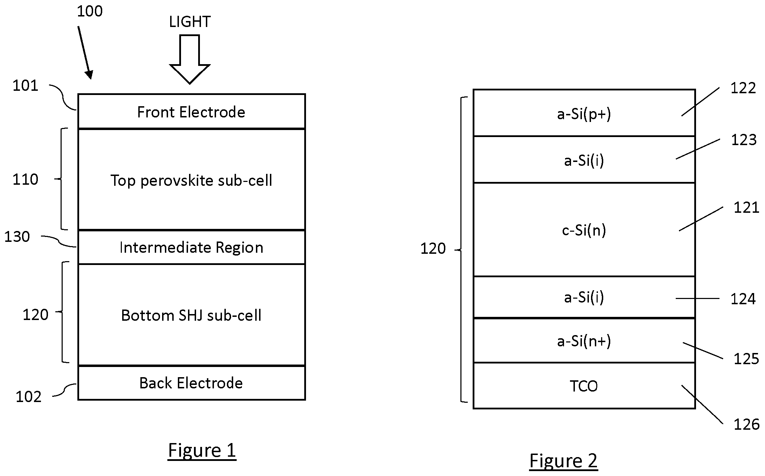

Figure 1 illustrates schematically a monolithically integrated multi-junction photovoltaic device 100 that comprises a first/top sub-cell 110 comprising a photoactive region that comprises a perovskite material, whilst the second/bottom sub-cell 120 comprises a silicon heterojunction (SHJ). The multi-junction photovoltaic device 100 has a monolithically integrated structure and therefore comprises just two electrodes, a front/first electrode 101 and a back/second electrode 102, with the first/top sub-cell 110 and the second/bottom sub-cell 120 disposed between these two electrodes. In particular, the first sub-cell 110 is in contact with the first/front electrode 101 and the second sub-cell 120 is in contact with the second/back electrode 102. The monolithically integrated multi-junction photovoltaic device 100 typically also comprises a metal grid on the top surface of the front/first electrode 101 as a top contact (not shown). By way of example, the top contact could be provided a metal grid or fingers produced by screen printing of a silver and/or copper paste.

In addition, as the monolithically integrated structure comprises just two electrodes, the first and second sub-cells 110, 120 are then connected to one another by an intermediate region 130 comprising one or more interconnect layers. For example, the interconnect layer(s) can comprise any of a recombination layer and a tunnel junction. In a monolithically integrated multi-junction photovoltaic device the individual sub-cells are electrically connected in series, which results in the need for a recombination layer or a tunnel junction and current matching between the sub-cells.

The perovskite material in the photoactive region of the first sub-cell 110 is configured to function as a light absorber (i.e. photosensitizer) within the photoactive region. As the top sub-cell in a multi-junction device, the perovskite material therefore preferably has a band gap from 1.50eV to 1.75eV, and more preferably from 1.65eV to 1.70eV. The second sub-cell comprising the silicon heterojunction (SHJ) then preferably has a band gap of around 1.1 eV.

In addition, the perovskite material in the photoactive region of the first sub-cell 110 may also be configured to provide charge transport. In this regard, perovskite materials are able to act not only a light absorber (i.e. photosensitizer) but also as an n-type, p-type or intrinsic (i-type) semiconductor material (charge transporter). A perovskite material can therefore act both as a photosensitizer and as the n-type semiconductor material. The perovskite material may therefore assume the roles both of light absorption and long range charge transport.

Figure 2 illustrates schematically an example of the second/bottom sub-cell 120 that comprises a silicon heterojunction (SHJ). In this regard, the term silicon heterojunction (SHJ) refers to an amorphous silicon/crystalline silicon heterojunction that makes use of a crystalline silicon (c-Si) wafer 121 as a photoactive absorber and amorphous silicon (a-Si) thin-films 122, 123, 124, 125 for junction formation and surface passivation. A silicon heterojunction (SHJ) is sometimes also referred to as a heterojunction with intrinsic thin layer (HIT) when any thin layers of intrinsic amorphous silicon (a-Si) are present as passivation/buffer layers. A silicon heterojunction (SHJ) therefore typically comprises a p-type a-Si emitter 122, an intrinsic a-Si passivation/buffer layer 123, an n-type c-Si photoactive absorber 121, another intrinsic a-Si passivation/buffer layer 124, and a back-surface field (BSF) layer made of n-type a-Si 125. Optionally, a silicon heterojunction (SHJ) can further comprise a layer of a transparent conducting oxide (TCO) (e.g. ITO) 126 between the back-surface field (BSF) layer 125 and the back electrode 102. When present, this rear layer of TCO assists in maximising the infrared response by increasing internal reflectance at the rear surface.

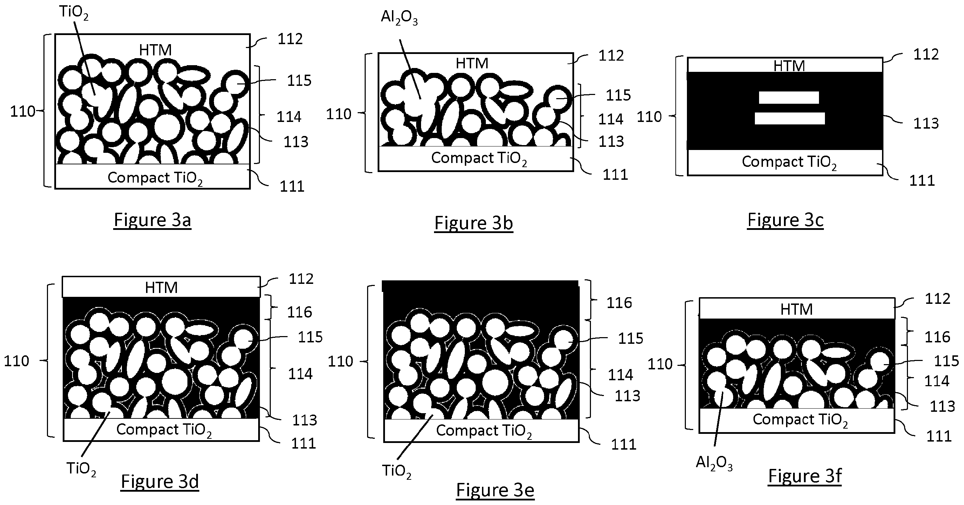

The use of a silicon heterojunction (SHJ) as the second/bottom sub-cell 120 has a number of advantages. Firstly, single-junction solar cells based on silicon heterojunction (SHJ) technology have been shown to achieve records energy conversion efficiencies of over 25%, which maximises the potential for a multi-junction device comprising a silicon heterojunction (SHJ) cell to achieve high efficiencies. Secondly, as the silicon heterojunction (SHJ) makes use of an n-type c-Si photoactive absorber 121 with a p-type a-Si emitter 122, the formation of the perovskite-based first sub-cell 110 on the second sub-cell 120 as a substrate is initiated by the deposition of the n-type layers followed by the sequential deposition of the perovskite material and the p-type layers, which the present inventors have found has advantages when processing a monolithically integrated perovskite-on-silicon multi-junction photovoltaic device. Figures 3a to 3f then illustrate schematically various examples of the first/top sub-cell 110 that that comprises a photoactive perovskite material.

In Figures 3a and 3b, the first/top sub-cell 110 of the photovoltaic device 100 comprises a porous region 114, wherein the porous region 114 comprises a layer of the perovskite material 113 of formula (I) that does not fall within the claimed invention and that is in contact with a porous scaffold material 115 that is disposed between an n-type region 111 and a p-type region 112. In these structures, the layer of the perovskite material 113 is provided as a coating on the porous scaffold material 115, thereby forming a substantially conformal layer on the surface of the porous scaffold, such that the perovskite material 113 is disposed within pores of the porous scaffold. The p-type region 112 comprises a charge transporting material that then fills the pores of porous region 114 (i.e. the pores of the perovskite-coated porous scaffold) and forms a capping layer over the porous material. In this regard, the capping layer of charge transporting material consists of a layer of the charge transporting material without open porosity.

In Figure 3a, the illustrated first/top sub-cell 110 has what has been referred to as an extremely thin absorber (ETA) cell architecture in which an extremely thin layer of the light absorbing perovskite material is provided at the interface between nanostructured, interpenetrating n-type (e.g. TiO2) and p-type semiconductors (e.g. HTM). In this arrangement, the porous scaffold material 115 within the first/top sub-cell 110 comprises a semiconducting/charge transporting material.

In Figure 3b, the illustrated first/top sub-cell 110 has what has been referred to as a meso-superstructured solar cell (MSSC) architecture in which an extremely thin layer of the light absorbing perovskite material is provided on a mesoporous insulating scaffold material. In this arrangement, the porous scaffold material 115 within the first/top sub-cell 110 comprises a dielectric material (e.g. Al₂O₃).

In Figure 3c, the first/top sub-cell 110 comprising a layer of the perovskite material 113 of formula (I) without open porosity does not fall within the claimed invention. As described above, a material without open porosity typically has no macropores and no mesopores, but may have micropores and nanopores (and therefore may have intercrystalline pores). The layer of perovskite material 113 therefore forms a planar heterojunction with one or both of the n-type region 111 and the p-type region 112. Either the n-type region 111 or the p-type region 112 may be disposed on the layer of the perovskite material 113 without open porosity. In this regard, as the layer of the perovskite material 113 is without open porosity, no n-type or p-type material infiltrates the perovskite material to form a bulk heterojunction; rather it forms a planar heterojunction with the perovskite material. Typically, the layer of the perovskite material 113 without open porosity is in contact with both the n-type region and the p-type region, and therefore forms a planar heterojunction with both the n-type region and the p-type region.

In Figure 3c, the illustrated first/top sub-cell 110 therefore has a thin film planar heterojunction device architecture in which a solid thin layer of the light absorbing perovskite material is provided between planar layers of n-type (e.g. TiO₂) and p-type semiconductors (e.g. HTM). In this arrangement, the device does not include a porous scaffold material.

Figures 3d, 3e, and 3f then illustrate examples of the first/top sub-cell 110 that are similar to those illustrated in Figures 3a and 3b; however, rather than the perovskite material 113 forming a substantially conformal layer on the surface of the porous scaffold material 115, the porous scaffold material 115 is infiltrated by the perovskite material 113. The perovskite material 113 therefore fills the pores of the porous scaffold material 115 and forms what can be considered to be a bulk heterojunction with the porous scaffold material 115. In some examples, the perovskite material 113 also forms a capping layer 116 of the perovskite material over the porous scaffold material 115. Typically, the capping layer 116 consists of a layer of the perovskite material without open porosity and, in some examples, forms a planar heterojunction with a charge transporting region disposed over the perovskite material.

In Figure 3d, the perovskite material 113 fully infiltrates the nanostructured n-type (e.g. TiO2) and forms a planar heterojunction with the p-type semiconductors (e.g. HTM). In this arrangement, the porous scaffold material 115 within the first/top sub-cell 110 comprises a semiconducting/charge transporting material.

In Figure 3e, the illustrated first/top sub-cell 110 is substantially the same as that illustrated in Figure 3d; however, it includes only one charge transporting region. In this regard, it has been shown that functional photovoltaic devices comprising a photoactive perovskite can be formed without any hole-transporting materials, such that the photoactive perovskite is in direct contact with an electrode and/or metal layer (see Etgar, L., Gao, P. & Xue, Z., 2012. Mesoscopic CH3NH3Pbl3/TiO2 heterojunction solar cells. J. Am. Chem. Soc., 2012, 134 (42), pp 17396-17399). In such devices, the photoactive perovskite assumes the roles of both light harvester and hole transporter, such that an additional hole transporting material is redundant. The first/top sub-cell 110 of Figure 3e therefore does not include a p-type region, whilst the perovskite material 113 fully infiltrates the nanostructured n-type material (e.g. TiO2).

In Figure 3f, the illustrated first/top sub-cell 110 is similar to that illustrated in Figure 3b; however, the perovskite material 113 fully infiltrates the mesoporous insulating scaffold material (Al₂O₃) and forms a planar heterojunction with the p-type semiconductors (e.g. HTM).

In an alternative structure, the photoactive region may comprise a layer of the perovskite material of formula (I) wherein the perovskite material is itself porous and which does not fall within the claimed invention. A charge transporting material then fills the pores of porous region of perovskite material and forms a capping layer over the porous perovskite material. In this regard, the capping layer of charge transporting material consists of a layer of the charge transporting material without open porosity.

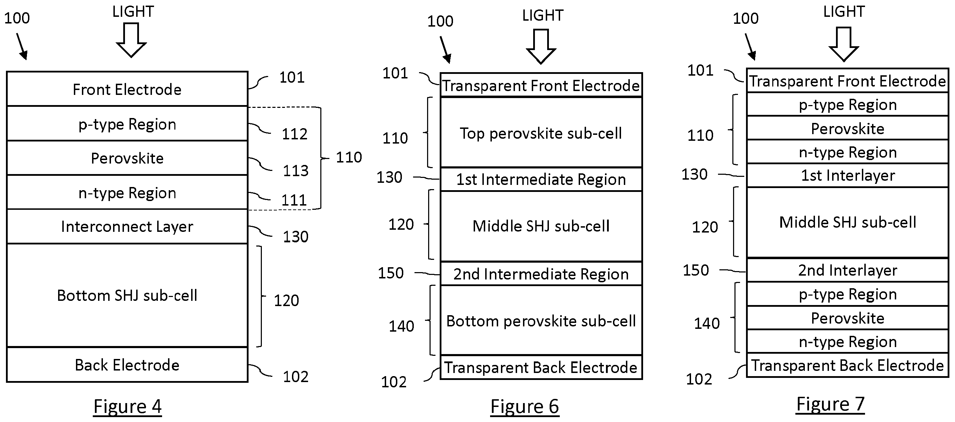

Figure 4 illustrates schematically an example of a monolithically integrated multi-junction photovoltaic device 100 in which the first/top sub-cell 110 comprises a photoactive region in which the photoactive perovskite material 113 is provided as a planar layer. In the example of Figure 4, the photoactive region of the first sub-cell 110 comprises an n-type region 111 comprising at least one n-type layer, a p-type region 112 comprising at least one p-type layer, and the planar layer of the perovskite material 113 disposed between the n-type region and the p-type region. The first and second sub-cells 110, 120 are then connected to one another by an intermediate region 130 that comprises an interconnect layer.

In this arrangement, the planar layer of perovskite material 113 is considered to be without open porosity 113. As described above, a material without open porosity typically has no macropores and no mesopores, but may have micropores and nanopores (and therefore may have intercrystalline pores). In this regard, as the layer of the perovskite material 113 is without open porosity, no n-type or p-type material infiltrates the perovskite material to form a bulk heterojunction; rather it forms a planar heterojunction with the perovskite material. Typically, the layer of the perovskite material 113 without open porosity is in contact with both the n-type region and the p-type region, and therefore forms a planar heterojunction with both the n-type region and the p-type region. The first sub-cell 110 can therefore be described as having a planar heterojunction architecture (similar to that of the first sub-cell 110 described above and illustrated in Figure 3c).

As noted above, given that the second/bottom sub-cell 120 comprises a silicon heterojunction (SHJ) in which the photoactive absorber is n-type c-Si 121 and the emitter is p-type a-Si 122, the first/top sub-cell 110 of the multi-junction photovoltaic device 100 is arranged such that the n-type region 111 is adjacent to the second sub-cell 120. In other words, the n-type region 111 is next to the second sub-cell 120 and is therefore nearer to the second-sub-cell 120 than the p-type region 112. In particular, it is the n-type region 111 of the first sub-cell 110 that contacts the intermediate region 130 that connects the first sub-cell 110 to the second-sub-cell 120. The p-type region 112 of the first sub-cell 110 is therefore in contact with the first electrode 101. The front/first electrode 101 therefore functions as a positive (hole collecting) electrode, whilst the second/back electrode 102 functions as a negative (electron collecting) electrode.

In the above described multi-junction photovoltaic devices, the p-type region of the first sub-cell comprises one or more p-type layers. Often, the p-type region is a p-type layer, i.e. a single p-type layer. In other examples, however, the p-type region may comprise a p-type layer and a p-type exciton blocking layer or electron blocking layer. If the valence band (or highest occupied molecular orbital energy levels) of the exciton blocking layer is closely aligned with the valence band of the photoactive material, then holes can pass from the photoactive material into and through the exciton blocking layer, or through the exciton blocking layer and into the photoactive material, and we term this a p-type exciton blocking layer. An example of such is tris[4-(5-phenylthiophen-2-yl)phenyl]amine, as described in Masaya Hirade, and Chihaya Adachi, "Small molecular organic photovoltaic cells with exciton blocking layer at anode interface for improved device performance" Appl. Phys. Lett. 99, 153302 (2011).

A p-type layer is a layer of a hole-transporting (i.e. a p-type) material. The p-type material may be a single p-type compound or elemental material, or a mixture of two or more p-type compounds or elemental materials, which may be undoped or doped with one or more dopant elements.

A p-type layer may comprise an inorganic or an organic p-type material. Typically, the p-type region comprises a layer of an organic p-type material.

Suitable p-type materials may be selected from polymeric or molecular hole transporters. The p-type layer employed in the photovoltaic device of the invention may for instance comprise spiro-OMeTAD (2,2',7,7'-tetrakis-(N,N-di-p-methoxyphenylamine)9,9'-spirobifluorene)), P3HT (poly(3-hexylthiophene)), PCPDTBT (Poly[2,1,3-benzothiadiazole-4,7-diyl[4,4-bis(2-ethylhexyl)-4H-cyclopenta[2,1-b:3,4-b']dithiophene-2,6-diyl]]), PVK (poly(N-vinylcarbazole)), HTM-TFSI (1-hexyl-3-methylimidazolium bis(trifluoromethylsulfonyl)imide), Li-TFSI (lithium bis(trifluoromethanesulfonyl)imide) or tBP (tert-butylpyridine). The p-type region may comprise carbon nanotubes. Usually, the p-type material is selected from spiro-OMeTAD, P3HT, PCPDTBT and PVK. Preferably, the p-type region consists of a p-type layer that comprises spiro-MeOTAD.

A p-type layer may for example comprise spiro-OMeTAD (2,2',7,7'-tetrakis-(N,N-di-p-methoxyphenylamine)9,9'-spirobifluorene)), P3HT (poly(3-hexylthiophene)), PCPDTBT (Poly[2,1,3-benzothiadiazole-4,7-diyl[4,4-bis(2-ethylhexyl)-4H-cyclopenta[2,1-b:3,4-b']dithiophene-2,6-diyl]]), or PVK (poly(N-vinylcarbazole)).

Suitable p-type materials also include molecular hole transporters, polymeric hole transporters and copolymer hole transporters. The p-type material may for instance be a molecular hole transporting material, a polymer or copolymer comprising one or more of the following moieties: thiophenyl, phenelenyl, dithiazolyl, benzothiazolyl, diketopyrrolopyrrolyl, ethoxydithiophenyl, amino, triphenyl amino, carbozolyl, ethylene dioxythiophenyl, dioxythiophenyl, or fluorenyl. Thus, a p-type layer employed in the photovoltaic device of the invention may for instance comprise any of the aforementioned molecular hole transporting materials, polymers or copolymers.

Suitable p-type materials also include m-MTDATA (4,4',4"-tris(methylphenylphenylamino)triphenylamine), MeOTPD (*N*,*N,N',N*'-tetrakis(4-methoxyphenyl)-benzidine), BP2T (5,5'-di(biphenyl-4-yl)-2,2'-bithiophene), Di-NPB (*N*,*N*'-Di-[(1-naphthyl)-*N*,*N*'-diphenyl]-1,1'-biphenyl)-4,4'-diamine), α-NPB (N,N'-di(naphthalen-1-yl)-N,N'-diphenyl-benzidine), TNATA (4,4',4"-tris-(N-(naphthylen-2-yl)-N-phenylamine)triphenylamine), BPAPF (9,9-bis[4-(N,N-bis-biphenyl-4-yl-amino)phenyl]-9H-fluorene), spiro-NPB (N2,N7-Di-1-naphthalenyl-N2,N7-diphenyl-9,9'-spirobi[9H-fluorene]-2,7-diamine), 4P-TPD (4,4-bis-(*N*,*N*-diphenylamino)-tetraphenyl), PEDOT:PSS and spiro-OMeTAD.

A p-type layer may be doped, for instance with tertbutyl pyridine and LiTFSI. A p-type layer may be doped to increase the hole-density. A p-type layer may for instance be doped with NOBF₄ (Nitrosonium tetrafluoroborate), to increase the hole-density.

In other examples, a p-type layer may comprise an inorganic hole transporter. For instance, a p-type layer may comprise an inorganic hole transporter comprising an oxide of nickel, vanadium, copper or molybdenum; Cul, CuBr, CuSCN, Cu₂O, CuO or CIS; a perovskite; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped. A p-type layer may be a compact layer of said inorganic hole transporter.

A p-type layer may for instance comprise an inorganic hole transporter comprising an oxide of nickel, vanadium, copper or molybdenum; Cul, CuBr, CuSCN, Cu₂O, CuO or CIS; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped. Ap-type layer may for instance comprise an inorganic hole transporter selected from Cul, CuBr, CuSCN, Cu₂O, CuO and ClS. A p-type layer may be a compact layer of said inorganic hole transporter.

The p-type region may have a thickness of from 50 nm to 1000 nm. For instance, the p-type region may have a thickness of from 50 nm to 500 nm, or from 100 nm to 500 nm. In the above described multi-junction photovoltaic devices, the p-type region 112 of the first sub-cell preferably has a thickness from 200 nm to 300 nm, and more preferably of approximately 250 nm.

In the above described multi-junction photovoltaic device, the n-type region of the first sub-cell comprises one or more n-type layers. Often, the n-type region is an n-type layer, i.e. a single n-type layer. In other examples, however, the n-type region may comprise an n-type layer and a separate n-type exciton blocking layer or hole blocking layer.

An exciton blocking layer is a material which is of wider band gap than the photoactive material, but has either its conduction band or valance band closely matched with those of the photoactive material. If the conduction band (or lowest unoccupied molecular orbital energy levels) of the exciton blocking layer are closely aligned with the conduction band of the photoactive material, then electrons can pass from the photoactive material into and through the exciton blocking layer, or through the exciton blocking layer and into the photoactive material, and we term this an n-type exciton blocking layer. An example of such is bathocuproine (BCP), as described in P. Peumans, A. Yakimov, and S. R. Forrest, "Small molecular weight organic thin-film photodetectors and solar cells" J. Appl. Phys. 93, 3693 (2001) and Masaya Hirade, and Chihaya Adachi, "Small molecular organic photovoltaic cells with exciton blocking layer at anode interface for improved device performance" Appl. Phys. Lett. 99, 153302 (2011)}.

An n-type layer is a layer of an electron-transporting (i.e. an n-type) material. The n-type material may be a single n-type compound or elemental material, or a mixture of two or more n-type compounds or elemental materials, which may be undoped or doped with one or more dopant elements.

A n-type layer employed may comprise an inorganic or an organic n-type material.

A suitable inorganic n-type material may be selected from a metal oxide, a metal sulphide, a metal selenide, a metal telluride, a perovskite, amorphous Si, an n-type group IV semiconductor, an n-type group III-V semiconductor, an n-type group II-VI semiconductor, an n-type group I-VII semiconductor, an n-type group IV-VI semiconductor, an n-type group V-VI semiconductor, and an n-type group II-V semiconductor, any of which may be doped or undoped.

The n-type material may be selected from a metal oxide, a metal sulphide, a metal selenide, a metal telluride, amorphous Si, an n-type group IV semiconductor, an n-type group III-V semiconductor, an n-type group II-VI semiconductor, an n-type group I-VII semiconductor, an n-type group IV-VI semiconductor, an n-type group V-VI semiconductor, and an n-type group II-V semiconductor, any of which may be doped or undoped.

More typically, the n-type material is selected from a metal oxide, a metal sulphide, a metal selenide, and a metal telluride.

Thus, an n-type layer may comprise an inorganic material selected from oxide of titanium, tin, zinc, niobium, tantalum, tungsten, indium, gallium, neodymium, palladium, or cadmium, or an oxide of a mixture of two or more of said metals. For instance, an n-type layer may comprise TiO₂, SnO₂, ZnO, Nb₂O₅, Ta₂O₅, WO₃, W₂O₅, In₂O₃, Ga₂O₃, Nd₂O₃, PbO, or CdO.

Other suitable n-type materials that may be employed include sulphides of cadmium, tin, copper, or zinc, including sulphides of a mixture of two or more of said metals. For instance, the sulphide may be FeS₂, CdS, ZnS, SnS, BiS, SbS, or Cu₂ZnSnS₄.

An n-type layer may for instance comprise a selenide of cadmium, zinc, indium, or gallium or a selenide of a mixture of two or more of said metals; or a telluride of cadmium, zinc, cadmium or tin, or a telluride of a mixture of two or more of said metals. For instance, the selenide may be Cu(In,Ga)Se₂. Typically, the telluride is a telluride of cadmium, zinc, cadmium or tin. For instance, the telluride may be CdTe.

An n-type layer may for instance comprise an inorganic material selected from oxide of titanium, tin, zinc, niobium, tantalum, tungsten, indium, gallium, neodymium, palladium, cadmium, or an oxide of a mixture of two or more of said metals; a sulphide of cadmium, tin, copper, zinc or a sulphide of a mixture of two or more of said metals; a selenide of cadmium, zinc, indium, gallium or a selenide of a mixture of two or more of said metals; or a telluride of cadmium, zinc, cadmium or tin, or a telluride of a mixture of two or more of said metals.

Examples of other semiconductors that may be suitable n-type materials, for instance if they are n-doped, include group IV elemental or compound semiconductors; amorphous Si; group III-V semiconductors (e.g. gallium arsenide); group II-VI semiconductors (e.g. cadmium selenide); group I-VII semiconductors (e.g. cuprous chloride); group IV-VI semiconductors (e.g. lead selenide); group V-VI semiconductors (e.g. bismuth telluride); and group II-V semiconductors (e.g. cadmium arsenide).

Typically, the n-type layer comprises TiO₂.

When an n-type layer is an inorganic material, for instance TiO₂ or any of the other materials listed above, it may be a compact layer of said inorganic material. Preferably the n-type layer is a compact layer of TiO₂.

Other n-type materials may also be employed, including organic and polymeric electron-transporting materials, and electrolytes. Suitable examples include, but are not limited to a fullerene or a fullerene derivative, an organic electron transporting material comprising perylene or a derivative thereof, or poly{[N,N0-bis(2-octyldodecyl)-naphthalene-1,4,5,8-bis(dicarboximide)-2,6-diyl]-alt-5,50-(2,20-bithiophene)} (P(NDI2OD-T2)). For example, the n-type region may comprise a n-type layer comprising one or more of C60, C70, C84, C60-PCBM, C70-PCBM, C84-PCBM and carbon nanotubes.

The n-type region may have a thickness of from 5 nm to 1000 nm. Where the n-type region comprises a compact layer of an n-type semiconductor, the compact layer has a thickness of from 5 nm to 200 nm. In the above described multi-junction photovoltaic device, the n-type region 111 of the first sub-cell 110 preferably has a thickness from 10 nm to 1000 nm, more preferably 20 nm to 40 nm, and yet more preferably of approximately 30nm.

In the above described multi-junction photovoltaic devices, the intermediate region 130 can comprise one or more interconnect layers. By way of example, an interconnect layer may comprise a transparent conductive oxide (TCO) such as indium tin oxide (ITO) or aluminium doped zinc oxide (AZO), carbons (e.g. graphene), metal nanowires etc. Typically, the intermediate region comprises an interconnect layer that consists of indium tin oxide (ITO) that acts as a recombination layer. Preferably the interconnect layer of ITO has a thickness of from 10 nm to 60nm, and more preferably a thickness of approximately 50 nm.

The back electrode 102 typically comprises a high work function metal such as gold (Au) silver (Ag), nickel (Ni), palladium (Pd), platinum (Pt) or aluminium (Al).

### Device Structure - Transparent Electrode

In the above described multi-junction photovoltaic device, the first/front electrode 101 is the electrode provided on that side or surface of the photovoltaic device that it is intended will be directly exposed to sun light. The first electrode 101 is therefore required to be transparent so as to maximise the transmission of the light through the electrode to the photoactive layers of the first and second sub-cells 110, 120 provided beneath, whilst also having sufficient electrical conductivity. In particular, for multi-junction devices, the first electrode should transmit a large proportion of light over the complete optical window (i.e. from 400 nm to 1200 nm in wavelength) as transmission of the longer wavelengths is highly important for achieving useful power conversion efficiencies.

The first electrode 101 therefore preferably consists of material that has a sheet resistance (Rs) from 10 ohms per square (Ω/sq) to 100 Ω/sq and an average transmission for visible and infrared light of at least 85% (i.e. transmits at least 85% of light from 400 nm to 1200 nm in wavelength). More preferably, the first electrode 101 consists of material that has a sheet resistance (Rs) of equal to or less than 50 Ω/sq and an average transmission for visible and infrared light of greater than 90%, and preferably has an average transmission for visible and infrared light of at least 95%.

Particularly suitable materials for use as the transparent front electrode include transparent conductive oxides (TCO). Transparent conductive oxides (TCO) are doped metal oxides that are electrically conductive and have a comparably low absorption of light. TCOs can have greater than 80% transmittance of incident light as well as conductivities higher than 10⁴ S/cm (i.e. resistivity of ~10⁻⁴ Ω·cm) for efficient carrier transport. Examples of suitable TCO materials include indium tin oxide (ITO), aluminium doped zinc oxide (AZO), fluorine doped tin oxide (FTO), indium-doped zinc oxide (IZO), niobium-doped titanium dioxide (Nb:TiO₂) etc.

The first electrode 101 therefore preferably comprises of a layer of transparent conductive oxides (TCO). By way of example, the first electrode 101 can comprise of a layer of any of indium tin oxide (ITO), aluminium doped zinc oxide (AZO), fluorine doped tin oxide (FTO), indium-doped zinc oxide (IZO), and niobium-doped titanium dioxide (Nb:TiO₂). More preferably, the first electrode 101 therefore preferably consists of a layer of indium tin oxide (ITO). When the first electrode 101 consists of a layer of indium tin oxide (ITO) it is preferable that the layer has a thickness of from 100 nm to 200 nm, and more preferably of 150 nm.

Conventional techniques for fabrication of layers of TCO materials typically involve a magnetron sputtering process. However, there are various drawbacks to the use of conventional magnetron sputtering when depositing layers of TCO materials. In particular, whilst conventional magnetron sputtering captures free electrons in a magnetic field directly above the target surface, the resulting plasma is still relatively diffuse and must therefore be high energy in order to produce layers of sufficient quality. Using a high energy plasma in a conventional magnetron sputtering process results in high energy target atoms striking the surface of the substrate that can therefore result in damage if the surface of the substrate is sensitive, as would be the case when the substrate comprises an organic material. Whilst it is possible to reduce the power and thereby lower the energy of the plasma used in the process, this reduces the quality of the layers deposited by conventional magnetron sputtering, producing disordered/irregular structures with defects that can act as traps thereby reducing carrier mobility, increasing the resistivity and decreasing transmission.

Consequently, in order to be able to make use of organic charge transport material in the p-type region of the first sub-cell 110, without the need for an additional protective inorganic buffer layer, use is made of a sputtering process that involves a remotely generated plasma to deposit a layer of TCO as the first electrode 101. The term "remotely generated plasma" refers to a plasma whose generation does not rely on the sputtering target (as is the case in conventional magnetron sputtering). The remotely generated plasma is guided to the sputtering target by a shaped electromagnetic field produced by a pair of electromagnets resulting in a high density plasma (e.g. 10¹¹ cm⁻³ or more) uniformly over the full surface area of the target.

The use of a remotely generated plasma for the sputtering deposition process decouples the generation of the plasma from the biasing of the target, thereby enabling the generation of a high density (as high as 5 × 10¹³ cm⁻³) yet low energy plasma. In this regard, using remote plasma sputtering, the energy of the ions in the plasma is typically in the region of 30 to 50 eV, which would be insufficient to sputter from the target in a conventional magnetron sputtering process. Using remote plasma sputtering, it is then possible to control the energy of the sputtering, regardless of the energy of the plasma, by controlling the bias applied to the target.

This low energy sputtering process is found not only to prevent damage to the substrate, but also to produce a layer of TCO with good short range order and with sufficiently fewer defects thereby improving the carrier mobility and optical transmission of the resulting layer when compared with layers generated using conventional magnetron sputtering. This is particularly significant for multi-junction photovoltaic devices in which it is important that as much light as possible reaches the multiple photoactive layers within the device.

In particular, for an exemplary layer of TCO, this improvement in the quality of the resulting layer will improve the carrier mobility whilst also limiting the carrier concentration (e.g. ~1×10²¹ cm⁻³) for improved transmission of greater than 90% for visible and infrared light (i.e. light above 400nm in wavelength) whilst still providing low resistivity (e.g. ~7×10⁻⁴ Ω.cm, equivalent to a sheet resistance of ~50 Ω/sq for a layer of ~150 nm in thickness). Using conventional techniques, TCO layers that achieve such characteristics require either high sputter target power densities (and therefore high damage) or high temperature annealing during their fabrication, which is not compatible with substrates that are comprised materials that are therefore sensitive to high temperatures.

In addition, the use of a remotely generated plasma for the sputtering deposition process allows the structure of the resulting TCO layer to be finely controlled by modifying/tuning any of the plasma power, the bias applied to the target, and the pressure of the sputtering gas. Modifying the plasma power changes the ion density of the plasma, whilst modifying the target bias will affect the sputter energy, and modifying the pressure can impact both the reactivity and the kinetic energy of the species arriving at the substrate. By way of example, such control enables the production of a dense, homogeneous amorphous layer of TCO that has good short range order and low defects, which would therefore be suitable for use as a barrier layer for protecting the layers beneath. In particular, the lack of defects and grain boundaries prevents the ingress of moisture through the TCO layer. Similarly, such control also enables the production of layers of TCO that graduate between an amorphous structure and a crystalline structure. The amorphous portions could then provide a barrier layer whilst the crystalline portions provide improved conductivity. Furthermore, this control can be used to eliminate stress of the TCO layer during deposition, resulting in a layer that is more robust, less likely to crack, and has improved adhesion.

Whilst the above described examples relate to a layer of TCO for use as the front electrode of a multi-junction photovoltaic device, layers of TCO having the beneficial characteristics produced as a result of the use of a remotely generated plasma for the sputtering deposition process are equally applicable to other optoelectronic devices, including single junction photovoltaic devices, light emitting devices etc. Furthermore, whilst the above described examples related to the use of a layer of TCO that is deposited onto the p-type region of the perovskite-based solar cell, it is equally applicable to an inverted structure in which the TCO layer is deposited onto an n-type material.

Consequently, there is also provided a photovoltaic device comprising a photoactive layer, a layer of organic charge transport material above the photoactive layer, and a layer of TCO that has been deposited onto the layer of organic charge transport material wherein the layer of TCO has a sheet resistance (Rₛ) equal to or less than 50 ohms per square (Ω/sq) and an average transmission for visible and infrared light of greater than 90% (i.e. transmits at least 90% of light above 400nm in wavelength), and that preferably has an average transmission for visible and infrared light of at least 95 %. In addition, there is also provided a method of producing a photovoltaic device comprising depositing a photoactive layer, depositing a layer of organic charge transport material onto the photoactive layer, and depositing a layer of TCO onto the organic charge transport material using remote plasma sputtering. Advantageously, in this method, the step of depositing the layer of TCO can be performed at temperatures below 100°C. In addition, this method also does not require an additional step in which the deposited layer of TCO is annealed at temperatures of 200°C or higher. In preferred examples, the photoactive layer comprises a photoactive perovskite material.

### Device Structure - Perovskite Material

In the above described multi-junction photovoltaic devices, the first sub-cell 110 comprises a photoactive region that comprises a perovskite material. The perovskite material in the photoactive region of the first sub-cell 110 is configured to function as a light absorber/a photosensitizer within the photoactive region. The perovskite material then preferably has a band gap from 1.50eV to 1.75eV, and more preferably from 1.65eV to 1.70eV. The second sub-cell comprising the silicon heterojunction (SHJ) then preferably has a band gap of around 1.1 eV.

In the inventive multi-junction photovoltaic device, the first sub-cell is disposed over a second sub-cell, the first sub-cell comprises an n-type region comprising at least one n-type layer, a p-type region comprising at least one p-type layer, and a photoactive region comprising a layer of perovskite without open porosity that is disposed between the n-type region and the p-type region and that forms a planar heterojuntion with one or both of the n-type region and the p-type region, the perovskite material having the general formula:

AₓA'₁₋ₓB(X_{y}X'_{1-y})₃ (IA)

wherein A is formamidinium (FA), A' is a caesium cation (Cs⁺), B is Pb²⁺, X is iodide and X' is bromide, and wherein 0 < x < 1 and 0 < y ≤ 1, and the second sub-cell comprises a silicon heterojunction (SHJ). The perovskite material therefore comprises a mixture of two monovalent cations. In addition, in the preferred embodiments, the perovskite material can therefore comprise either a single iodide anion or a mixture of iodide and bromide anions. The present inventors have found such perovskite materials can have band gaps in from 1.50eV to 1.75eV and that layers of such perovskite materials can be readily formed with suitable crystalline morphologies and phases.

Accordingly, the perovskite material is FAₓCs₁₋ₓPbI_{3-y}Br_{y} with x and y as defined for formula (IA) above.

In order to provide highly efficient photovoltaic devices, the absorption of the absorber should ideally be maximised so as to generate an optimal amount of current. Consequently, when using a perovskite as the absorber in a photovoltaic device or sub-cell, the thickness of the perovskite layer should ideally be in the order of from 300 to 600nm, in order to absorb most of the sun light across the visible spectrum. Typically, therefore, the thickness of the layer of the perovskite material is greater than 100nm. The thickness of the layer of the perovskite material in the photovoltaic device may for instance be from 100 nm to 1000 nm. The thickness of the layer of the perovskite material in the photovoltaic device may for instance be from 200 nm to 700 nm, and is preferably from 300nm to 600nm. In the above described multi-junction photovoltaic devices, the planar layer of perovskite material 113 in the photoactive region of the first/top sub-cell 110 preferably has a thickness from 350 nm to 450 nm, and more preferably of approximately 400nm.

### Device Structure - Second Sub-cell Surface Profile

When developing a monolithically integrated perovskite-on-silicon multi-junction photovoltaic device one of the most important considerations is the interface between the perovskite sub-cell and the adjacent crystalline silicon bottom sub-cell. In this regard, as described in Schneider, B.W. et al and Filipic, M. et al. referred to above, conventional commercial crystalline silicon solar cells feature textured surfaces that are designed to reduce reflection and increase the optical path length, with these surface textures usually consisting of randomly distributed pyramids, prepared by etching along the faces of the crystal planes, or regular inverted pyramids. These textured surfaces therefore present significant problems for the processing of monolithically integrated perovskite-on-silicon photovoltaic devices, as the overall thickness of the perovskite sub-cell is typically similar to the roughness of the textured surface. For example, the surface roughness of a conventional crystalline silicon solar cell is typically in the range of 500 nm to 10 µm, whilst the thickness of a perovskite cell is typically less than 1 µm. In particular, whilst Schneider, B.W. et al and Filipic, M. et al. attempt to model perovskite-on-silicon tandem cells in which a conformal thin film perovskite sub-cell is deposited onto the textured front surface of a silicon bottom sub-cell, neither document propose a method for achieving this conformal deposition. Furthermore, Bailie, C. et al states that the development of monolithic tandem cell incorporating a perovskite top cell will likely need to planarize the surface silicon bottom cell (i.e. to reduce the roughness of the surface/remove any surface texture).

Consequently, the only prior working example of a monolithically integrated perovskite-on-silicon multi-junction photovoltaic device make use of a silicon bottom sub-cell with a planar top surface in order to simplify the deposition of the perovskite, despite the recognition that this lowers the efficiency of the silicon bottom sub-cell (see Mailoa, J.P. et al. referenced above). Whilst this approach circumvents the problems associated with the deposition of the perovskite cell, this would require the mechanical polishing of conventional crystalline silicon solar cells in order to create a planar surface, thereby increasing the processing costs and reducing the efficiency of the silicon cells.

In contrast, the present inventors have found that it is possible to produce a monolithically integrated perovskite-on-silicon multi-junction photovoltaic device that maintains the majority of the efficiency benefits that arise from the presence texturing of the top surface of the silicon bottom sub-cell whilst also enabling the deposition of the layers that comprise the perovskite top sub-cell with suitable morphologies. In particular, the present inventors have found an advantageous surface profile for the top surface of the silicon bottom sub-cell that allows for the straightforward conformal deposition of the layers of the perovskite top sub-cell whilst also allowing for an increase in the efficiency of the silicon bottom sub-cell of approximately 1% when compared with a silicon bottom sub-cell that has a planar, non-textured top surface.

In this regard, the present inventors have determined that it is possible to obtain functioning tandems when depositing the perovskite sub-cell on a silicon bottom sub-cell for which the surface adjacent to the perovskite sub-cell is textured with a roughness average (Rₐ) of less than 500 nm. As described above, in the context of silicon-based photovoltaic devices the term "textured" refers to a surface of a device on which an artificial uneven surface profile has been intentionally created, e.g. using an etching process.

The present inventors have also determined that a roughness average (Rₐ) of between 50 and 450 nm is preferred, as this simplifies the deposition of the layers of the perovskite sub-cell without completely losing the benefits provided by surface texturing of the silicon bottom sub-cell. In particular, a roughness average (Rₐ) of between 100 and 400 nm is likely to produce the most efficient devices, depending upon the particular perovskite used and the thickness of the perovskite layer to be deposited over the silicon bottom cell. In the exemplary embodiments described herein, the preferred roughness average (Rₐ) for the surface of the silicon bottom sub-cell that is adjacent to the perovskite sub-cell is from 200 nm to 400 nm.

It is therefore preferable that the surface 127 of the second sub-cell 120 that is adjacent to the first sub-cell 110 has a roughness average (Rₐ) of less than 500 nm. It is yet more preferable that the surface 127 of the second sub-cell 120 that is adjacent to the first sub-cell 110 has a roughness average (Rₐ) of between 50 and 450 nm. In a preferred embodiment, the surface 127 of the second sub-cell 120 that is adjacent to the first sub-cell 110 has a roughness average (Rₐ) of between 100 and 400 nm, and more preferable has a roughness average (Rₐ) from 200 nm to 400 nm.

In preferred examples, the surface 127 of the second sub-cell 120 that is adjacent to the first sub-cell 110 has a root mean square roughness (Rᵣₘₛ) of less than or equal to 50 nm. It is then also preferable that the surface 127 of the second sub-cell 120 that is adjacent to the first sub-cell 110 has a peak-to-peak roughness (Rₜ) from 100 nm to 400 nm, and preferably of approximately 250 nm. Furthermore, it is preferable that the surface 127 of the second sub-cell 120 that is adjacent to the first sub-cell 110 has a mean spacing between peaks (Sₘ) from 10 µm to 50 µm, and preferably of approximately 25 µm. Moreover, it is preferably that the surface 127 of the second sub-cell 120 that is adjacent to the first sub-cell 110 has an undulating profile (i.e. the profile has a wavy form or outline, such that the changes in the height of the surface are substantially smooth). The layers above the second sub-cell 120 (e.g. the interconnect layers 130 and the layers that make up the first sub-cell110) are then each deposited as substantially continuous and conformal layers that conforms to the adjacent surface of the second sub-cell 120.

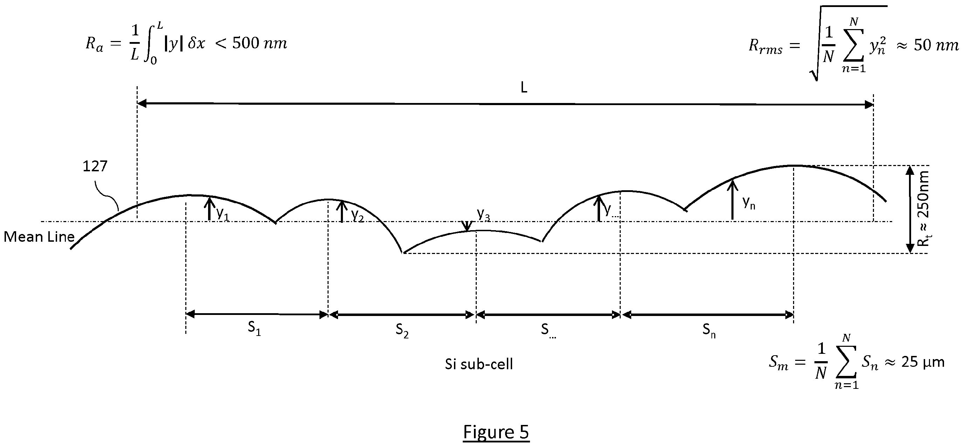

By way of example, Figure 5 illustrates schematically (not to scale) a specific example of the surface profile of the second sub-cell 120 in which the textured surface has a roughness average (Rₐ) of less than 500 nm (i.e. over a sampling length, L), the peak-to-peak roughness (Rₜ) is approximately 250 nm, the root mean square roughness (Rᵣₘₛ) is approximately 50 nm, and the mean spacing between peaks (Sₘ) is approximately 25 µm. In addition, it can also be seen that the surface 127 of the second sub-cell 120 that is adjacent to the first sub-cell 110 has an undulating profile such that the changes in the height of the surface are substantially smooth.

### Alternative Device Structure - General

In the above described examples, the multi-junction photovoltaic device could be considered to be monofacial, such that it is configured to only collect light and generate electricity through its front, sun-exposed face. However, the majority of the features described above are equally applicable to a bifacial multi-junction photovoltaic device that can collect light and generate electricity through both of its faces; the front, sun-exposed face and the rear face. In particular, the present inventors have recognised that the multi-junction photovoltaic device could be configured into a bifacial architecture, with a further, perovskite-based sub-cell provided beneath the second sub-cell in order to boost the energy conversion efficiency of the second sub-cell with respect to the light absorbed from the rear side of the device.

Figure 6 therefore illustrates schematically a bifacial monolithically integrated multi-junction photovoltaic device 100 that comprises a first/top sub-cell 110 that comprises a photoactive region that comprises a perovskite material, a second/middle sub-cell 120 that comprises a silicon heterojunction (SHJ), and a third/bottom sub-cell 140 that comprises a photoactive region that comprises a perovskite material. The multi-junction photovoltaic device 100 has a monolithically integrated structure and therefore comprises just two electrodes, a front/first electrode 101 and a back/second electrode 102, with the first sub-cell 110, the second sub-cell 120, and the third sub-cell 140 disposed between these two electrodes. In particular, the first sub-cell 110 is in contact with the first electrode 101, the third sub-cell 140 is in contact with the second/back electrode 102, and the second sub-cell 120 is disposed between the first sub-cell 110 and the third sub-cell 140..

As the monolithically integrated structure comprises just two electrodes, the first and second sub-cells 110, 120 are then connected to one another by a first intermediate region 130 comprising one or more interconnect layers, and the second and third sub-cells 120, 140 are then connected to one another by a second intermediate region 150 comprising one or more interconnect layers.

As with the devices described above, the perovskite material in the photoactive region of the first sub-cell 110 is configured to function as a light absorber/photosensitizer within the photoactive region. The perovskite material then preferably has a band gap from 1.50eV to 1.75eV, and more preferably from 1.65eV to 1.70eV. The second sub-cell comprising the silicon heterojunction (SHJ) then preferably has a band gap of around 1.1 eV. The perovskite material in the photoactive region of the third sub-cell 140 is also configured to function as a light absorber/photosensitizer within the photoactive region, and therefore preferably has a band gap from 1.50eV to 1.75eV, and more preferably from 1.65eV to 1.70eV.

The perovskite material in the photoactive region of the third sub-cell 140 may therefore be the same as the perovskite material in the photoactive region of the first sub-cell 110 or may be different to the perovskite material in the photoactive region of the first sub-cell 110. In any case, the perovskite material in the photoactive region of the third sub-cell 140 preferably corresponds to the preferred perovskite materials described herein.

Figure 7 illustrates schematically a more detailed example of a bifacial monolithically integrated multi-junction photovoltaic device 100. In the example of Figure 7, the structure photoactive region of the first sub-cell 110 corresponds with that described with reference to and illustrated in Figure 3. The photoactive region of the third sub-cell 140 then comprises a photoactive region in which the photoactive perovskite material is provided as a planar layer 143. The photoactive region of the third sub-cell 140 further comprises an n-type region 142 comprising at least one n-type layer, a p-type region 141 comprising at least one p-type layer, and the planar layer of the perovskite material 143 disposed between the n-type region and the p-type region.

In this arrangement, the planar layer of perovskite material 143 in the third sub-cell 140 is considered to be without open porosity. Typically, the layer of the perovskite material 143 without open porosity is in contact with both the n-type region and the p-type region, and therefore forms a planar heterojunction with both the n-type region and the p-type region. The third sub-cell 140 can therefore be described as having a planar heterojunction architecture.

As noted above, given that the second/middle sub-cell 120 comprises a silicon heterojunction (SHJ) in which the photoactive absorber is n-type c-Si 121 and the emitter is p-type a-Si 122, the first/top sub-cell 110 of the multi-junction photovoltaic device 100 is arranged such that the n-type region 111 is adjacent to the second sub-cell 120. In other words, the n-type region 111 is next to the second sub-cell 120 and is therefore nearer to the second-sub-cell 120 than the p-type region 112. In particular, it is the n-type region 111 of the first sub-cell 110 that contacts the first intermediate region 130 that connects the first sub-cell 110 to the second-sub-cell 120. The p-type region 112 of the first sub-cell 110 is therefore in contact with the first electrode 101. The front/first electrode 101 therefore functions as a positive (hole collecting) electrode.

Similarly, given that the second/middle sub-cell 120 comprises a silicon heterojunction (SHJ) in which the photoactive absorber is n-type c-Si 121 and the back-surface field (BSF) layer is n-type a-Si 125, the third/bottom sub-cell of the multi-junction photovoltaic device 100 is arranged such that the p-type region 141 is adjacent to the second sub-cell 120. In other words, the p-type region 141 is next to the second sub-cell 120 and is therefore nearer to the second-sub-cell 120 than the n-type region 142. In particular, it is the p-type region 141 of the third sub-cell 140 that contacts the second intermediate region 150 that connects the third sub-cell 140 to the second-sub-cell 120. The third sub-cell 140 can therefore be considered to be inverted when compared to the first sub-cell 110, as the order in which the layers would be deposited onto the second sub-cell 120 during manufacture would be reversed. The n-type region 142 of the third sub-cell 140 is therefore in contact with the second electrode 102, and the second/back electrode 102 therefore functions as a negative (electron collecting) electrode.

In the bifacial multi-junction photovoltaic device each of the p-type region 141 and the n-type region 142 can be of the same composition and structure as the respective p-type region 112 and the n-type region 111 of the first sub-cell 110. Alternatively, each of the p-type region 141 and the n-type region 142 may be of a different composition and structure to the p-type region 112 and n-type region 111 of the first sub-cell 110. In any case, the composition and structure of each of the p-type region 141 and the n-type region 142 of the third sub-cell 140 may for instance be selected from among those described herein with respect to the p-type region 112 and the n-type region 111 of the first sub-cell 110.

In a bifacial multi-junction photovoltaic device the second/back electrode 102 must be semi-transparent or transparent in order to allow light to be transmitted through to the photoactive layers of the device. It is therefore preferable that the second/back electrode 102 is of the same or similar composition and structure as that of the first/front electrode 101. The composition and structure second/back electrode 102 may therefore be selected from among those described herein with respect to the first electrode 101.

It is also preferable that the surface 128 of the second sub-cell 120 that is adjacent to the third sub-cell 140 has the same or a similar surface profile as that of the surface 127 of the second sub-cell 120 that is adjacent to the first sub-cell 110. It is therefore preferable that surface profile of the surface 128 of the second sub-cell 120 that is adjacent to the third sub-cell 140 is as described above with respect to the surface 127 of the second sub-cell 120 that is adjacent to the first sub-cell 110.

### Not Claimed Examples

In the examples detailed below, pre-fabricated n-type crystalline silicon heterojunction (SHJ) sub-cells were obtained on which customised chemical-polishing had been applied to the front/top surface followed by a blanket coated layer of ITO as an interconnect layer. The front/top surface of the silicon heterojunction (SHJ) sub-cell was then cleaned using an oxygen plasma treatment.

For the multi-junction devices, a layer of n-type material was then deposited on to front/top surface of the silicon heterojunction (SHJ) sub-cell using thermal exaporation. Subsequently, a layer of perovskite material of formula MAPb(I_{0.8}Br_{0.2})₃, where MA is methlyammonium (CH₃NH₃⁺) was formed by spin coating deposition from a solution. In these examples, solid precursors for the perovskite materials were weighed and mixed together in a vial. This mixture was then loaded into a glovebox where the solvent was added. The cell was then finished by depositing a thin layer of a p-type material by spin coating from solution, and a patterned gold electrode by physical vapour deposition.

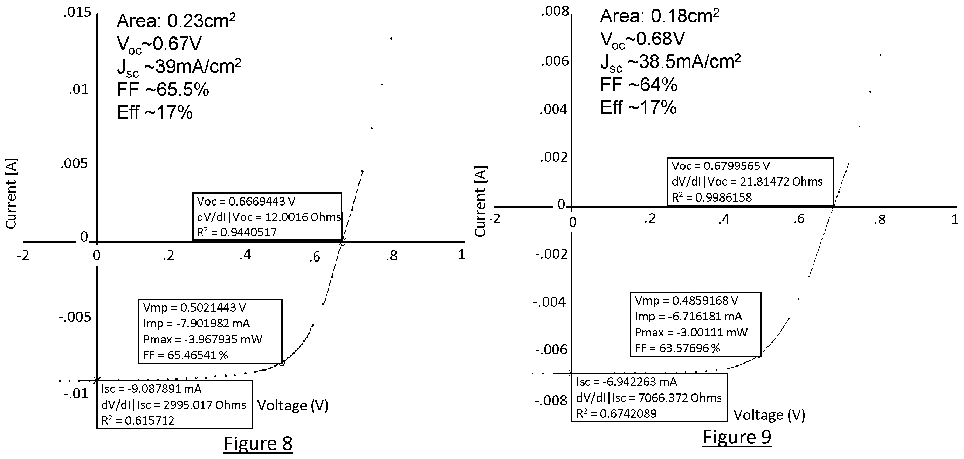

Figures 8 and 9 show I-V curves and the calculated device characteristics for samples of the n-type crystalline silicon heterojunction (SHJ) sub-cells when measured as a single junction device under simulated AM 1.5G (100 mW/cm2) solar irradiation. The calculated power conversion efficiencies (η) for each of these silicon heterojunction (SHJ) sub-cells is approximately 17%.

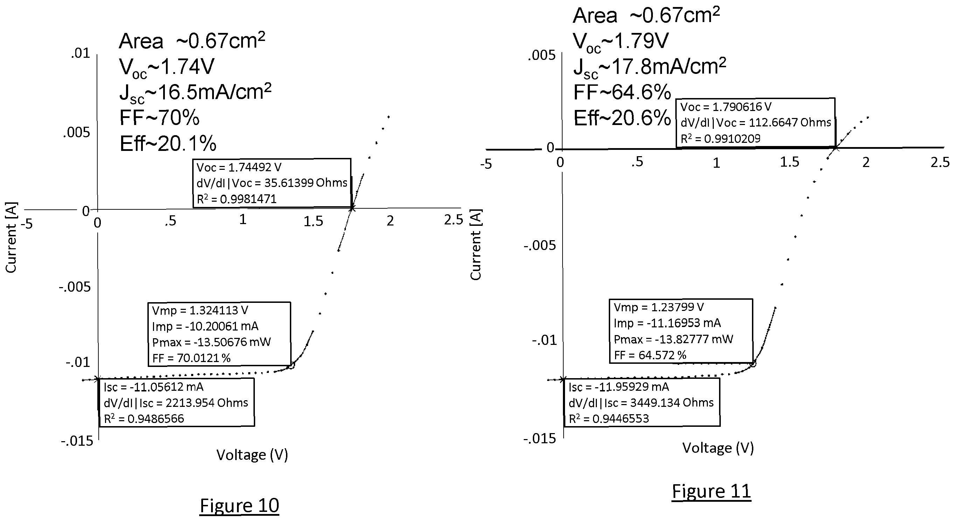

In comparison, Figures 10 and 11 then show I-V curves and the calculated device characteristics for multi-junction devices that each comprise a perovskite-based sub-cell monolithically integrated on to the n-type crystalline silicon heterojunction (SHJ) sub-cells. The calculated power conversion efficiencies (η) for these multi-junction devices are 20.1% and 20.6%, a net gain in efficiency of approximately 3% over the single junction crystalline silicon heterojunction (SHJ) sub-cells.

## Claims

1. A multi-junction photovoltaic device comprising:
a first sub-cell disposed over a second sub-cell,
wherein the first sub-cell comprises an n-type region comprising at least one n-type layer, a p-type region comprising at least one p-type layer, and a photoactive region comprising a layer of perovskite material without open porosity that is disposed between the n-type region and the p-type region and that forms a planar heterojunction with one or both of the n-type region and the p-type region;
wherein the perovskite material is of general formula (IA):
AₓA'₁₋ₓB(X_{y}X'_{1-y})₃ (IA)
wherein A is a formamidinium cation (FA) (HC(NH)₂)₂⁺), A' is a caesium cation (Cs⁺), B is Pb²⁺, X is iodide and X' is bromide, 0 < y ≤ 1 and
wherein the second sub-cell comprises a silicon heterojunction (SHJ), **characterized by** 0 < x <1 in formula (IA).

2. The multi-junction photovoltaic device according to claim 1, wherein the layer of perovskite material is disposed as a substantially continuous and conformal layer on a surface that conforms to the adjacent surface of the second sub-cell.

3. The multi-junction photovoltaic device according to any preceding claim, and further comprising an intermediate region disposed between and connecting the first sub-cell and the second sub-cell, wherein the intermediate region comprises one or more interconnect layers.

4. The multi-junction photovoltaic device according to claim 3, wherein each of the one or more interconnect layers comprises a transparent conductor material.

5. The multi-junction photovoltaic device according to any of claims 3 to 4, wherein the intermediate region comprises an interconnect layer that consists of indium tin oxide (ITO).

6. The multi-junction photovoltaic device according to claim 5 wherein the layer of ITO has a thickness of from 10 nm to 60nm.

7. The multi-junction photovoltaic device according to any preceding claim, wherein the n-type region comprises an n-type layer that comprises an inorganic n-type material.

8. The multi-junction photovoltaic device according to claim 7, wherein the inorganic n-type material is selected from any of:
an oxide of titanium, tin, zinc, niobium, tantalum, tungsten, indium, gallium, neodymium, palladium, cadmium, or an oxide of a mixture of two or more of said metals;
a sulphide of cadmium, tin, copper, zinc or a sulphide of a mixture of two or more of said metals;
a selenide of cadmium, zinc, indium, gallium or a selenide of a mixture of two or more of said metals; and
a telluride of cadmium, zinc, cadmium or tin, or a telluride of a mixture of two or more of said metals.

9. The multi-junction photovoltaic device according to any of claims 7 or 8, wherein the n-type region comprises an n-type layer that comprises TiO₂.

10. The multi-junction photovoltaic device according to any of claims 1 to 6, wherein the n-type region comprises an n-type layer that comprises an organic n-type material.

11. The multi-junction photovoltaic device according to claim 10, wherein the organic n-type material is selected from any of a fullerene or a fullerene derivative, a perylene or a derivative thereof, or poly{[N,N0-bis(2-octyldodecyl)-naphthalene-1,4,5,8-bis(dicarboximide)-2,6-diyl]-alt-5,50-(2,20-bithiophene)} (P(NDI2OD-T2)).

12. The multi-junction photovoltaic device according to any preceding claim, wherein the p-type region comprises a p-type layer that comprises an inorganic p-type material.

13. The multi-junction photovoltaic device according to claim 12, wherein the inorganic p-type material is selected from any of:
an oxide of nickel, vanadium, copper or molybdenum; and
Cul, CuBr, CuSCN, Cu2O, CuO or CIS.

14. The multi-junction photovoltaic device according to any of claims 1 to 11, wherein the p-type region comprises a p-type layer that comprises an organic p-type material.

15. The multi-junction photovoltaic device according to claim 14, wherein the organic p-type material is selected from any of spiro-MeOTAD, P3HT, PCPDTBT, PVK, PEDOT-TMA, PEDOT:PSS.

16. The multi-junction photovoltaic device according to any of claims 1 to 15, wherein the n-type region is adjacent to the second sub-cell.

17. The multi-junction photovoltaic device according to any preceding claim, and further comprising:
a first electrode and a second electrode; and
wherein the first sub-cell and the second sub-cell are disposed between the first and second electrodes with the first sub-cell in contact with the first electrode.

18. The multi-junction photovoltaic device according to claim 17, wherein the first electrode is in contact with the p-type region of the first sub-cell.

19. The multi-junction photovoltaic device according to any of claims 17 or 18, wherein the first electrode comprises a transparent or semi-transparent electrically conductive material.

20. The multi-junction photovoltaic device according to any of claims 16 to 19, wherein the first electrode consists of a layer of indium tin oxide (ITO).

21. The multi-junction photovoltaic device according to any preceding claim, wherein the photoactive region of the first sub-cell comprises a layer of perovskite material having a band gap from 1.50eV to 1.75eV.

22. The multi-junction photovoltaic device according to any preceding claim, wherein the second sub-cell comprises a bifacial sub-cell, and the device further comprises a third sub-cell disposed below the second sub-cell, the third sub-cell comprising a photoactive region comprising a layer of perovskite material.

23. The multi-junction photovoltaic device according to claim 22 wherein the photoactive region of the third sub-cell comprises a layer of perovskite material that is either the same as or different to the perovskite material of the photoactive region of the first sub-cell.

24. The multi-junction photovoltaic device according to any of claims 22 or 23 wherein the first sub-cell has a regular structure and the third sub-cell has an inverted structure.

25. The multi-junction photovoltaic device according to any of claims 22 to 24 and further comprising a further intermediate region disposed between and connecting the third sub-cell and the second sub-cell, wherein the further intermediate region comprises one or more further interconnect layers.

26. The multi-junction photovoltaic device according to claim 25 wherein each of the one or more further interconnect layers consists of a transparent conductor material.

27. The multi-junction photovoltaic device according to any of claims 25 to 26 wherein the intermediate region comprises a further interconnect layer that consists of indium tin oxide (ITO).

## Patentansprüche

1. Mehrfachübergangs-Photovoltaikvorrichtung, umfassend:
eine erste Unterzelle, die über einer zweiten Unterzelle angeordnet ist,
die erste Unterzelle umfassend einen n-leitenden Bereich, umfassend mindestens eine n-leitende Schicht, einen p-leitenden Bereich, umfassend mindestens eine p-leitende Schicht, und einen photoaktiven Bereich, umfassend eine Schicht aus Perowskitmaterial ohne offene Porosität, die zwischen dem n-leitenden Bereich und dem p-leitenden Bereich angeordnet ist und einen planaren Heteroübergang mit einem oder beiden von dem n-leitenden Bereich und dem p-leitenden Bereich bildet;
wobei das Perowskitmaterial von allgemeiner Formel (IA) ist:
AₓA'₁₋ₓB(X_{y}X'_{1-y})₃ (IA)
wobei A ein Formamidiniumkation (FA)(HC(NH)₂)₂⁺), A' ein Cäsiumkation (Cs+) ist, B Pb²⁺ ist, X Jodid ist und X' Bromid ist, 0 < y ≤ 1, und
wobei die zweite Unterzelle einen Siliziumheteroübergang (SHJ) umfasst, **gekennzeichnet durch** 0 < x <1 in Formel (IA).

2. Mehrfachübergangs-Photovoltaikvorrichtung nach Anspruch 1, wobei die Schicht aus Perowskitmaterial als eine im Wesentlichen durchgängige und konforme Schicht auf einer Oberfläche angeordnet ist, die sich an die angrenzende Oberfläche der zweiten Unterzelle anpasst.

3. Mehrfachübergangs-Photovoltaikvorrichtung nach einem vorherigen Anspruch, ferner umfassend einen Zwischenbereich, der zwischen der ersten Unterzelle und der zweiten Unterzelle angeordnet ist und diese verbindet, wobei der Zwischenbereich eine oder mehrere Verbindungsschichten umfasst.

4. Mehrfachübergangs-Photovoltaikvorrichtung nach Anspruch 3, wobei jede von der einen oder den mehreren Verbindungsschichten ein transparentes Leitermaterial umfasst.

5. Mehrfachübergangs-Photovoltaikvorrichtung nach einem der Ansprüche 3 bis 4, wobei der Zwischenbereich eine Verbindungsschicht umfasst, die aus Indiumzinnoxid (ITO) besteht.

6. Mehrfachübergangs-Photovoltaikvorrichtung nach Anspruch 5, wobei die Schicht aus ITO eine Stärke von 10 nm bis 60 nm aufweist.

7. Mehrfachübergangs-Photovoltaikvorrichtung nach einem vorherigen Anspruch, wobei der n-leitende Bereich eine n-leitende Schicht umfasst, die ein anorganisches n-leitendes Material umfasst.

8. Mehrfachübergangs-Photovoltaikvorrichtung nach Anspruch 7, wobei das anorganische n-leitende Material ausgewählt ist aus einem beliebigen von:
einemOxid von Titan, Zinn, Zink, Niob, Tantal, Wolfram, Indium, Gallium, Neodym, Palladium, Cadmium oder einem Oxid eines Gemischs aus zwei oder mehreren der genannten Metalle;
einem Sulfid von Cadmium, Zinn, Kupfer, Zink oder einem Sulfid eines Gemischs aus zwei oder mehreren der genannten Metalle;
einem Selenid von Cadmium, Zink, Indium, Gallium oder einem Selenid eines Gemischs aus zwei oder mehreren der genannten Metalle; und
einem Tellurid von Cadmium, Zink, Cadmium oder Zinn oder einem Tellurid eines Gemischs aus zwei oder mehreren der genannten Metalle.

9. Mehrfachübergangs-Photovoltaikvorrichtung nach einem der Ansprüche 7 oder 8, wobei der n-leitende Bereich eine n-leitende Schicht umfasst, die TiO₂ umfasst.

10. Mehrfachübergangs-Photovoltaikvorrichtung nach einem der Ansprüche 1 bis 6, wobei der n-leitende Bereich eine n-leitende Schicht umfasst, die ein organisches n-leitendes Material umfasst.

11. Mehrfachübergangs-Photovoltaikvorrichtung nach Anspruch 10, wobei das organische n-leitendes Material ausgewählt ist aus einem Fulleren oder einem Fullerenderivat, einem Perylen oder einem Derivat davon oder Poly{[N, N0-bis(2-octyldodecyl)-naphthalin-1,4,5,8-bis(dicarboximid) -2,6-diyl] -alt-5,50- (2,20-bithiophen)}(P(NDI2OD-T2)).

12. Mehrfachübergangs-Photovoltaikvorrichtung nach einem vorherigen Anspruch, wobei der p-leitende Bereich eine p-leitende Schicht umfasst, die ein anorganisches p-leitendes Material umfasst.

13. Mehrfachübergangs-Photovoltaikvorrichtung nach Anspruch 12, wobei das anorganische p-leitende Material ausgewählt ist aus einem beliebigen von:
einem Oxid von Nickel, Vanadium, Kupfer oder Molybdän; und
Cul, CuBr, CuSCN, Cu2O, CuO oder CIS.

14. Mehrfachübergangs-Photovoltaikvorrichtung nach einem der Ansprüche 1 bis 11, wobei der p-leitende Bereich eine p-leitende Schicht umfasst, die ein organisches p-leitendes Material umfasst.

15. Mehrfachübergangs-Photovoltaikvorrichtung nach Anspruch 14, wobei das organische p-leitende Material ausgewählt ist aus einem beliebigen von Spiro-MeOTAD, P3HT, PCPDTBT, PVK, PEDOT-TMA, PEDOT:PSS.

16. Mehrfachübergangs-Photovoltaikvorrichtung nach einem der Ansprüche 1 bis 15, wobei der n-leitende Bereich angrenzend an die zweite Unterzelle ist.

17. Mehrfachübergangs-Photovoltaikvorrichtung nach einem vorherigen Anspruch und ferner umfassend:
eine erste Elektrode und eine zweite Elektrode; und
wobei die erste Unterzelle und die zweite Unterzelle zwischen der ersten und zweiten Elektrode angeordnet sind, wobei die erste Unterzelle in Kontakt mit der ersten Elektrode ist.

18. Mehrfachübergangs-Photovoltaikvorrichtung nach Anspruch 17, wobei die erste Elektrode in Kontakt mit dem p-leitenden Bereich der ersten Unterzelle ist.

19. Mehrfachübergangs-Photovoltaikvorrichtung nach einem der Ansprüche 17 oder 18, wobei die erste Elektrode ein transparentes oder halbtransparentes elektrisch leitendes Material umfasst.

20. Mehrfachübergangs-Photovoltaikvorrichtung nach einem der Ansprüche 16 bis 19, wobei die erste Elektrode aus einer Schicht aus Indiumzinnoxid (ITO) besteht.

21. Mehrfachübergangs-Photovoltaikvorrichtung nach einem vorherigen Anspruch, wobei der photoaktive Bereich der ersten Unterzelle eine Schicht aus Perowskitmaterial mit einer Bandlücke von 1,50 eV bis 1,75 eV umfasst.

22. Mehrfachübergangs-Photovoltaikvorrichtung nach einem vorherigen Anspruch, wobei die zweite Unterzelle eine bifaziale Unterzelle umfasst und die Vorrichtung ferner eine dritte Unterzelle umfasst, die unter der zweiten Unterzelle angeordnet ist, wobei die dritte Unterzelle einen photoaktiven Bereich umfasst, der eine Schicht aus Perowskitmaterial umfasst.

23. Mehrfachübergangs-Photovoltaikvorrichtung nach Anspruch 22, wobei der photoaktive Bereich der dritten Unterzelle eine Schicht aus Perowskitmaterial umfasst, das entweder gleich wie das oder verschieden von dem Perowskitmaterial des photoaktiven Bereichs der ersten Unterzelle ist.

24. Mehrfachübergangs-Photovoltaikvorrichtung nach einem der Ansprüche 22 oder 23, wobei
die erste Unterzelle eine regelmäßige Struktur aufweist und die dritte Unterzelle eine invertierte Struktur aufweist.

25. Mehrfachübergangs-Photovoltaikvorrichtung nach einem der Ansprüche 22 bis 24, ferner umfassend einen weiteren Zwischenbereich, der zwischen der dritten Unterzelle und der zweiten Unterzelle angeordnet ist und diese verbindet, wobei der weitere Zwischenbereich eine oder mehrere weitere Verbindungsschichten umfasst.

26. Mehrfachübergangs-Photovoltaikvorrichtung nach Anspruch 25, wobei jede von der einen oder den mehreren weiteren Verbindungsschichten aus einem transparenten Leitermaterial besteht.

27. Mehrschicht-Photovoltaikvorrichtung nach einem der Ansprüche 25 bis 26, wobei der Zwischenbereich eine weitere Verbindungsschicht umfasst, die aus Indiumzinnoxid (ITO) besteht.

## Revendications

1. Dispositif photovoltaïque multijonction comprenant :
une première sous-cellule disposée sur une deuxième sous-cellule,
dans lequel la première sous-cellule comprend une région de type n comprenant au moins une couche de type n, une région de type p comprenant au moins une couche de type p, et une région photoactive comprenant une couche de matériau en pérovskite sans porosité ouverte qui est disposée entre la région de type n et la région de type p et qui forme une hétérojonction plane avec l'une ou les deux parmi la région de type n et de la région de type p ;
dans lequel le matériau en pérovskite est de formule générale (IA) :
AₓA'₁₋ₓB(X_{y}X'_{1-y})₃ (IA)
où A est un cation formamidinium (FA)(HC(NH)₂)₂⁺), A' est un cation césium (Cs+), B est Pb²⁺, X est un iodure et X' est un bromure, 0 < y ≤ 1 et
dans lequel la deuxième sous-cellule comprend une hétérojonction de silicium (SHJ), **caractérisée par** 0 < x < 1 dans la formule (IA).

2. Dispositif photovoltaïque multijonction selon la revendication 1, dans lequel la couche de matériau en pérovskite est disposée comme une couche sensiblement continue et conforme sur une surface qui se conforme à la surface adjacente de la deuxième sous-cellule.

3. Dispositif photovoltaïque multijonction selon l'une quelconque des revendications précédentes, et comprenant en outre une région intermédiaire disposée entre la première sous-cellule et la deuxième sous-cellule et les reliant, dans lequel la région intermédiaire comprend une ou plusieurs couches d'interconnexion.

4. Dispositif photovoltaïque multijonction selon la revendication 3, dans lequel chacune des une ou plusieurs couches d'interconnexion comprend un matériau conducteur transparent.

5. Dispositif photovoltaïque multijonction selon l'une quelconque des revendications 3 à 4, dans lequel la région intermédiaire comprend une couche d'interconnexion qui est constituée d'oxyde d'indium et d'étain (ITO).

6. Dispositif photovoltaïque multijonction selon la revendication 5, dans lequel la couche d'ITO a une épaisseur de 10 nm à 60 nm.

7. Dispositif photovoltaïque multijonction selon l'une quelconque des revendications précédentes, dans lequel la région de type n comprend une couche de type n qui comprend un matériau inorganique de type n.

8. Dispositif photovoltaïque multijonction selon la revendication 7, dans lequel le matériau inorganique de type n est choisi parmi l'un quelconque parmi :
un oxyde de titane, d'étain, de zinc, de niobium, de tantale, de tungstène, d'indium, de gallium, de néodyme, de palladium, de cadmium ou un oxyde d'un mélange de deux ou plusieurs desdits métaux ;
un sulfure de cadmium, d'étain, de cuivre, de zinc ou un sulfure d'un mélange de deux ou plusieurs desdits métaux ;
un séléniure de cadmium, de zinc, d'indium, de gallium ou un séléniure d'un mélange de deux ou plusieurs desdits métaux ; et
un tellurure de cadmium, de zinc, de cadmium ou d'étain, ou un tellurure d'un mélange de deux ou plusieurs desdits métaux.

9. Dispositif photovoltaïque multijonction selon l'une quelconque des revendications 7 ou 8, dans lequel la région de type n comprend une couche de type n qui comprend du TiOz.

10. Dispositif photovoltaïque multijonction selon l'une quelconque des revendications 1 à 6, dans lequel la région de type n comprend une couche de type n qui comprend un matériau organique de type n.

11. Dispositif photovoltaïque multijonction selon la revendication 10, dans lequel le matériau organique de type n est choisi parmi un fullerène ou un dérivé de fullerène, un pérylène ou un dérivé de celui-ci, ou un poly{[N, N0-bis (2-octyldodécyl)-naphtalène-1,4,5,8-bis(dicarboximide)-2,6-diyl]-alt-5,50- (2,20-bithiophène)} (P(NDI2OD-T2)).

12. Dispositif photovoltaïque multijonction selon l'une quelconque des revendications précédentes, dans lequel la région de type p comprend une couche de type p qui comprend un matériau inorganique de type p.

13. Dispositif photovoltaïque multijonction selon la revendication 12, dans lequel le matériau inorganique de type p est choisi parmi l'un quelconque parmi :
un oxyde de nickel, de vanadium, de cuivre ou de molybdène ; et
Cul, CuBr, CuSCN, Cu2O, CuO ou CIS.

14. Dispositif photovoltaïque multijonction selon l'une quelconque des revendications 1 à 11, dans lequel la région de type p comprend une couche de type p qui comprend un matériau organique de type p.

15. Dispositif photovoltaïque multijonction selon la revendication 14, dans lequel le matériau organique de type p est choisi parmi l'un quelconque parmi spiro-MeOTAD, P3HT, PCPDTBT, PVK, PEDOT-TMA, PEDOT :PSS.

16. Dispositif photovoltaïque multijonction selon l'une quelconque des revendications 1 à 15, dans lequel la région de type n est adjacente à la deuxième sous-cellule.

17. Dispositif photovoltaïque multijonction selon l'une quelconque des revendications précédentes, et comprenant en outre :
une première électrode et une seconde électrode ; et
dans lequel la première sous-cellule et la deuxième sous-cellule sont disposées entre les première et seconde électrodes, la première sous-cellule étant en contact avec la première électrode.

18. Dispositif photovoltaïque multijonction selon la revendication 17, dans lequel la première électrode est en contact avec la région de type p de la première sous-cellule.

19. Dispositif photovoltaïque multijonction selon l'une quelconque des revendications 17 ou 18, dans lequel la première électrode comprend un matériau électriquement conducteur transparent ou semi-transparent.

20. Dispositif photovoltaïque multijonction selon l'une quelconque des revendications 16 à 19, dans lequel la première électrode consiste en une couche d'oxyde d'indium et d'étain (ITO).

21. Dispositif photovoltaïque multijonction selon l'une quelconque des revendications précédentes, dans lequel la région photoactive de la première sous-cellule comprend une couche de matériau en pérovskite ayant une bande interdite de 1,50 eV à 1,75 eV.

22. Dispositif photovoltaïque multijonction selon l'une quelconque des revendications précédentes, dans lequel la deuxième sous-cellule comprend une sous-cellule bifaciale, et le dispositif comprend en outre une troisième sous-cellule disposée sous la deuxième sous-cellule, la troisième sous-cellule comprenant une région photoactive comprenant une couche de matériau en pérovskite.

23. Dispositif photovoltaïque multijonction selon la revendication 22, dans lequel la région photoactive de la troisième sous-cellule comprend une couche de matériau en pérovskite qui est soit identique soit différente du matériau en pérovskite de la région photoactive de la première sous-cellule.

24. Dispositif photovoltaïque multijonction selon l'une quelconque des revendications 22 ou 23, dans lequel
la première sous-cellule a une structure régulière et la troisième sous-cellule a une structure inversée.

25. Dispositif photovoltaïque multijonction selon l'une quelconque des revendications 22 à 24 et comprenant en outre une autre région intermédiaire disposée entre la troisième sous-cellule et la deuxième sous-cellule et les reliant, dans lequel la région intermédiaire supplémentaire comprend une ou plusieurs couches d'interconnexion supplémentaires.

26. Dispositif photovoltaïque multijonction selon la revendication 25, dans lequel chacune des une ou plusieurs couches d'interconnexion supplémentaires est constituée d'un matériau conducteur transparent.

27. Dispositif photovoltaïque multijonction selon l'une quelconque des revendications 25 à 26, dans lequel
la région intermédiaire comprend une couche d'interconnexion supplémentaire constituée d'oxyde d'indium et d'étain (ITO).
